# EUROPEAN PATENT SPECIFICATION

(11) **EP 4 285 417 B1**
(45) Date of publication and mention of the grant of the patent: **02.09.2026**
(21) Application number: 21786165.7
(22) Date of filing: 29.09.2021
(51) Int. Cl.: H10D 30/66, H10D 30/01, H10D 62/10, H10D 62/13, H10D 62/17

(54) **SELF-ALIGNED CHANNEL METAL OXIDE SEMICONDUCTOR (MOS) DEVICE AND FABRICATION METHOD THEREOF**
SELBSTAUSRICHTENDE KANAL-METALLOXIDHALBLEITER-(MOS)-VORRICHTUNG UND VERFAHREN ZU IHRER HERSTELLUNG
DISPOSITIF MÉTAL-OXYDE SEMI-CONDUCTEUR (MOS) A CANAL AUTO-ALIGNE ET SON PROCEDE DE FABRICATION

(43) Date of publication of application: 06.12.2023
(73) Proprietor: Huawei Technologies Co., Ltd., Shenzhen, Guangdong 518129 (CN)
(72) Inventor: SLEDZIEWSKI, Tomasz, 80992 Munich (DE)
(74) Representative: Gill Jennings & Every LLP
(86) International application number: PCT/EP2021/076724
(87) International publication number: WO 2023/051898

(56) References cited:
- US-A1- 2012 223 338
- US-A1- 2016 141 371
- US-A1- 2017 229 535
- US-A1- 2017 243 970
- US-A1- 2021 126 123
- US-B2- 10 192 958

## Description

### TECHNICAL FIELD

The disclosure relates to the field of power semiconductor devices, in particular Metal Oxide Semiconductor (MOS) devices and Silicon Carbide (SiC) technology for power device applications. In particular, the disclosure relates to a self-aligned channel MOS device and a fabrication method for such device. The disclosure particularly relates to self-aligned channel SiC MOS devices.

### BACKGROUND

Power semiconductor devices comprise of thousands of elementary cells connected with each other in parallel. A key technological process which determines the cell integration is photolithography with its resolution and overlay accuracy. Self-aligned processes enable to exceed the photolithography capability without introducing any significant changes into the design. They can be applied just to one or some regions of the device, whereas the other regions remain unchanged. When applying self-aligned processes to SiC technology, the following problems can be observed.

SiC microfabrication requires ultra-high-temperature processing for implantation annealing, e.g., at about 1700 °C, thermal oxidation, e.g., at about 1300 °C and contact annealing, e.g., at about 1000 °C. The ultra-high-temperature processing differentiates SiC from Si technology and causes that not every microfabrication process developed for silicon can be transferred into the SiC technology. An example of the process not transferrable to the SiC technology is the self-aligned gate for Si CMOS, which uses a gate electrode as a mask for source and drain implantations. If this process was applied to SiC devices, the polysilicon gate with melting point at about 1414 °C would not survive the necessary implantation annealing at more elevated temperatures. Another example is the double diffusion process, commonly used for Si MOS power devices, which cannot be applied to SiC, because of a limited ion diffusion in this compound semiconductor even at elevated temperatures.

US-A-2021/126123 describes a method for manufacturing a MOSFET with lateral channel in SiC, said MOSFET comprising simultaneously formed n type regions comprising an access region and a JFET region defining the length of the MOS channel, and wherein the access region and the JFET region are formed by ion implantation by using one masking step.

US-A-2012/223338 describes a method of manufacturing a semiconductor device which includes the steps of forming a silicon oxide film on a silicon carbide substrate, annealing the silicon carbide substrate and the silicon oxide film in gas containing hydrogen, and forming an aluminum oxynitride film on the silicon oxide film after the annealing of the silicon carbide substrate and the silicon oxide film.

US-A-2016/141371 describes a silicon carbide semiconductor device that includes an n-type SiC epitaxial substrate, a p-type body layer, a p-type body layer potential fixing region and a nitrogen-introduced n-type first source region formed in the p-type body layer, an n-type second source region to which phosphorus which has a solid-solubility limit higher than that of nitrogen and is easily diffused is introduced is formed inside the nitrogen-introduced n-type first source region so as to be separated from both of the p-type body layer and the p-type body layer potential fixing region.

### SUMMARY

It is an object of this disclosure to provide a solution for a MOS device, in particular a SiC MOS device that can be efficiently manufactured without facing the above-mentioned problems.

In particular, it is an object of this disclosure to provide a MOS device, in particular a SiC MOS device with self-aligned channel that can be reliably manufactured using standard tools and processes available for front-end power semiconductor device fabrication in the industrial environment.

This object is achieved by the features of the independent claims. The invention provides a MOS device as defined by claim 1 and a method, as defined by claim 9, for producing a MOS device. Further implementation forms are apparent from the dependent claims, the description and the figures.

According to the embodiments of the disclosure, a double hard-mask fabrication process is used and further procedure is used to separate the source region defining the source of a power MOS device, e.g., a SiC power MOSFET, into two independent parts, which are: 1) Source contact; and 2) Lightly doped source. The source contact can be patterned and implanted prior to a first hard mask fabrication or after a double hard mask removal. The function of the source contact is to provide a low-ohmic access to the lightly doped source. Similarly, the body contact of the power MOSFET can be patterned and implanted prior to the first hard mask fabrication or after the double hard mask removal. The lightly doped source is implanted within the self-aligned channel process after creation of a spacer. The function of the lightly doped source is to achieve the self-alignment of the channel. The lightly doped source can be co-implanted into the body contact region of opposite doping type, i.e., semiconductor doping type, but because of the significantly lower doping concentration, i.e., semiconductor doping concentration, of the lightly doped source the doping concentration of the body contact is almost not compensated. Similarly, the lightly doped source can be co-implanted into the source contact of the same doping type, i.e., semiconductor doping type, but because of the significantly lower doping concentration, i.e., semiconductor doping concentration, of the lightly doped source the doping concentration of the source contact hardly increases. The contact function of the source contact and the channel definition function of the lightly doped source of the source region can be separated from each other in the presented solution.

The design concept of this disclosure introduces a self-aligned channel SiC MOS device and fabrication of such device, where source (e.g. emitter) region can be fabricated using two independent ion implantations where the first implantation is responsible for definition of the contact electrical properties and the second implantation is responsible for definition of the channel length where the second implantation co-implants the first implantation region and where the presence of both implantations is visible in the cross-section of the device.

The depth of the first implantation can be smaller or bigger than the depth of the second implantation.

The first and the second implantation can use different ions of the same doping type, i.e., semiconductor doping type.

The second implantation can be partially or fully removed from the contact region by over-etching of that region.

The body contact and the source contact have rectangular shape and alternate arrangement and the source contact can have a longer designed length than the body contact.

In this disclosure, self-aligned processes are described. Self-aligned processes enable to exceed the photolithography capability without introducing any significant changes into the design. They can be applied just to one or some regions of the device, whereas the other regions remain unchanged. An additional benefit of the self-alignment might be improved manufacturability and process reliability, as typical misalignments due to limited overlay accuracy are eliminated.

An example of a self-aligned process is the self-aligned gate which is a transistor manufacturing feature whereby a refractory gate electrode region of a MOSFET (metal-oxide-semiconductor field-effect transistor) is used as a mask for the doping of the source and drain regions. This technique ensures that the gate will slightly overlap the edges of the source and drain.

In order to describe the disclosure in detail, the following terms, abbreviations and notations will be used:
- SiC: Silicon Carbide
- MOS: Metal Oxide Semiconductor
- FET: Field Effect Transistor

According to a first aspect, the disclosure relates to a Metal-Oxide-Semiconductor, MOS, device, as defined by claim 1.

The MOS device can be a self-aligned MOS device that can be advantageously manufactured by introducing self-aligned processes. Self-aligned processes enable to exceed the photolithography capability without introducing any significant changes into the design. They can be applied just to one or some regions of the device, whereas the other regions remain unchanged. As an additional benefit, the self-aligned MOS device provides improved manufacturability and process reliability, as typical misalignments due to limited overlay accuracy are eliminated.

The separation of the source contact region, i.e., the first region of the current input electrode as defined above from the source channel region, i.e. the second region of the current input electrode as defined above has various advantages. The most important one is that for a MOS device with the self-aligned channel the small contacts can be fabricated on a flat wafer and that the full capability of the photolithography system can be used.

The MOS device according to the first aspect provides the following advantages:
The self-aligned channel process as defined by the body region and the lightly doped source, i.e., the second region as defined above, can be used for fabrication of a SiC MOS device, which allows for smaller elementary cell pitch and resulting larger cell integration density and resulting lower device resistance.

Small feature size source contact, i.e., first region as defined above, and body contact region, i.e. second region as defined above, can be patterned on a relatively flat wafer prior to the hard mask fabrication or after the hard mask removal. The flat topography allows for using full capability of the photolithography system and reduces the depth of focus issues. The manufacturability and process reliability are improved.

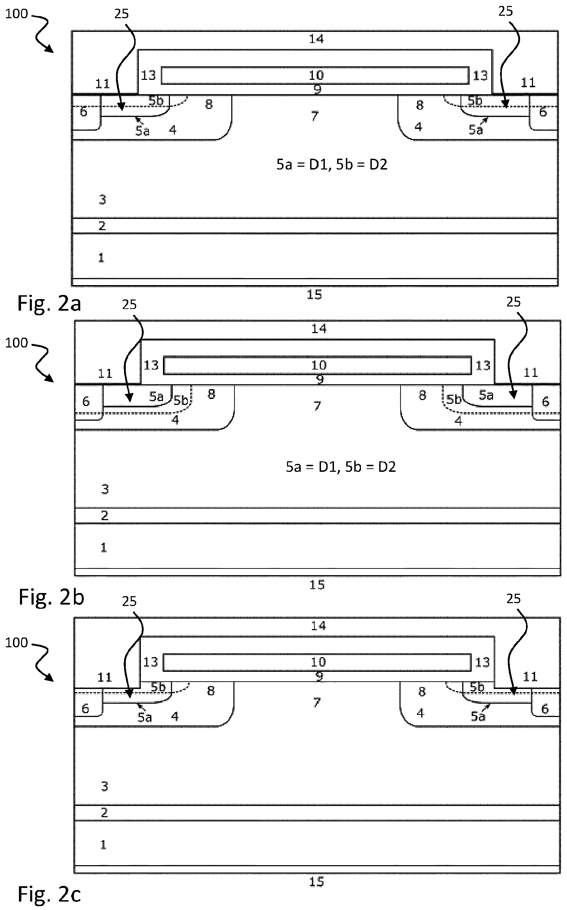

The source can be separated into the source contact, i.e., first region, and the lightly doped source, i.e., second region. Hence some properties of the source contact and the lightly doped source can be different, e.g., different doping species can be used for both regions and the ions can be implanted at different depths and the active contact region can be over-etched by dry etching without introducing any change into the channel region as shown for example in Figures 2c to 2e.

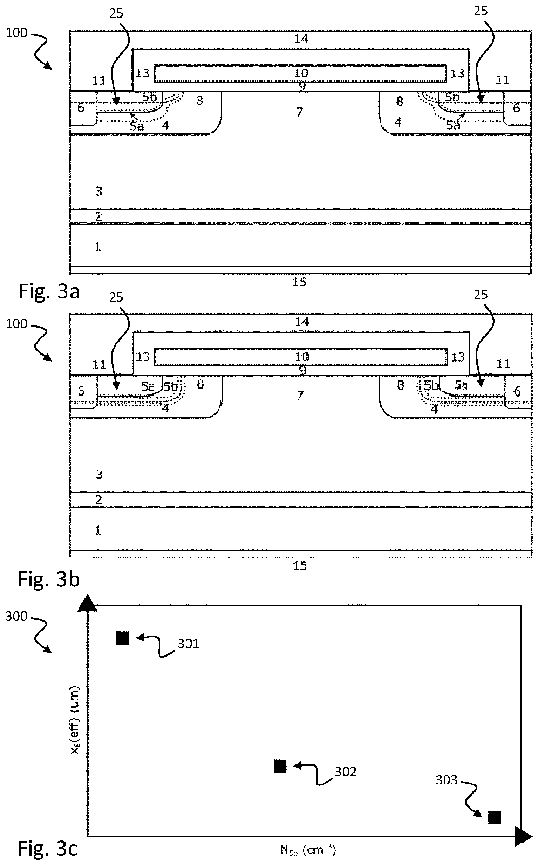

The lightly doped source in the proximity of the channel causes that the depletion region in the channel becomes narrower and the depletion region in the source (here in the lightly doped source) becomes wider, as presented for example in Figures 3a and 3b, which reduces the effect of decreased effective channel length and helps better control the channel length, which is especially important for the channels in the submicron range.

The MOS device comprises: a body contact region of the second semiconductor doping type electrically contacting the body region, the body contact region is configured to electrically contact the current input electrode.

Such a body contact region provides the technical advantage of a robust and reliable electrical connection between the body region and the current input electrode, e.g., the Source electrode.

In an exemplary implementation of the MOS device, a semiconductor doping concentration of the second region of the current input electrode is lower than a semiconductor doping concentration of the body contact region.

This feature provides the advantage of enabling a co-implantation of the second region of the current input electrode into the body contact region during a production of the MOS device without significant doping compensation of the body contact region and hence avoids an additional masking of the body contact region.

In the MOS device, a length of the channel is defined by a distance between the junction of the second region of the current input electrode to the body region and the junction of the body region to the JFET region.

This provides the advantage that the length of the channel can be flexibly designed according to requirements.

The first region of the current input electrode and the second region of the current input electrode comprise different ion implantations, particularly different dopant atoms of the same doping type.

This provides the advantage that the properties of these regions can be flexibly designed according to requirements.

In an exemplary implementation of the MOS device, a depth of the second region of the current input electrode is smaller than a depth of the first region and the current input electrode of the MOS device is shaped according to a step profile.

This provides the advantage that the properties of these regions can be flexibly designed according to requirements.

In an exemplary implementation of the MOS device, a depth of the second region of the current input electrode is bigger than a depth of the first region and the second region extends the first region in both vertical and lateral direction.

This provides the advantage that the properties of these regions can be flexibly designed according to requirements.

In an exemplary implementation of the MOS device, the body contact region is configured to extend through the body region into the drift layer.

This provides the advantage that the properties of the MOS device can be flexibly designed according to requirements.

In an exemplary implementation of the MOS device, a semiconductor doping concentration of the second region of the current input electrode is at least one order of magnitude lower than a semiconductor doping concentration of the first region of the current input electrode.

This provides the advantage that co-implantation of the second region into the first region hardly influences the electrical properties of the first region.

In a comparative example, the body contact region and the first region of the current input electrode are rectangularly shaped, wherein the rectangles of the body contact region and the rectangles of the first region of the current input electrode have a same length and are alternately arranged across the top side of the MOS device.

Such an arrangement of rectangular contacts allows for smaller cell pitch which results in higher cell integration density and lower device resistance.

In the MOS device of the invention, the body contact region and the first region of the current input electrode are rectangularly shaped, wherein the rectangles of the body contact region and the rectangles of the first region of the current input electrode are alternately arranged across the top side of the MOS device, and wherein the rectangles of the body contact region have a shorter length than the rectangles of the first region of the current input electrode.

Such an alternate arrangement of rectangular contacts allows for smaller cell pitch which results in higher cell integration density and lower device resistance.

In an exemplary implementation of the MOS device, the MOS device comprises: a MOSFET transistor with a gate electrode corresponding to the control electrode, a source electrode corresponding to the current input electrode and a drain electrode corresponding to the current output electrode; or an IGBT transistor with a gate electrode corresponding to the control electrode, an emitter electrode corresponding to the current input electrode and a collector electrode corresponding to the current output electrode.

This provides the advantage that such a MOS device can be applied in different electronic components such as MOSFET transistor and IGBT.

In an exemplary implementation of the MOS device, the channel of the MOS device is a self-aligned channel that is defined by a distance between the junction of the second region of the current input electrode to the body region and the junction of the body region to the JFET region.

Such a MOS device with self-aligned channel can be advantageously manufactured by introducing self-aligned processes. Self-aligned processes enable to exceed the photolithography capability without introducing any significant changes into the design. They can be applied just to one or some regions of the device, whereas the other regions remain unchanged. As an additional benefit, the self-aligned MOS device provides improved manufacturability and process reliability, as typical misalignments due to limited overlay accuracy are eliminated.

In an exemplary implementation of the MOS device, the MOS device comprises a Silicon Carbide power semiconductor device.

Implementation of the MOS device as a silicon carbide power semiconductor device offers meaningful benefits over silicon for fabrication of the power device, such as: Wide-bandgap, resulting in high maximum electric field and stable operation in wide-temperature range due to low intrinsic carrier density; High critical electric field, resulting in thinner and higher doped device drift layer and finally in lower device resistance; High thermal conductivity, resulting in excellent heat dissipation and finally in simple or no device cooling system; High drift electron velocity, resulting in high electron mobility at high electric fields and finally in low device resistance and fast switching; Small application weight and volume due to the above properties.

In an exemplary implementation of the MOS device, the control electrode is configured to overlap the second region of the current input electrode.

This feature has the advantageous technical effect that the overlap between control electrode such as gate and second region of the current input electrode, which is lightly doped source, determines the gate-source capacitance which has the impact on switching of the device. Switching means both switching on and switching off.

In an exemplary implementation of the MOS device, a length of the channel is based on the semiconductor doping concentration of the second region of the current input electrode.

The partitioning of the current input electrode into the first and second region provides the technical advantage that the semiconductor doping concentration of the second region can be used for tailoring the length of the channel.

The effective length of the channel, i.e. the final length of the channel, is specified by the length of the channel reduced by the total depletion layer length in the channel.

In an exemplary implementation of the MOS device, the MOS device comprises: an input contact metallization spreading over the body contact region and a part of the current input electrode, wherein a thickness of the first region of the current input electrode below the input contact metallization is smaller than a thickness of the first region of the current input electrode outside the input contact metallization.

This feature provides the advantage that the thinner part of the first region of the current input electrode may result from over-etching the current input electrode. By this over-etching, only the current input electrode region below the input contact metallization is influenced, i.e., the parameters of the channel region, particularly the channel depth, do not require any change due to intentional or foreseen uncontrolled over-etching in the first region of the current input electrode.

According to a second aspect, the disclosure relates to a method, as defined by claim 9, for producing a Metal-Oxide-Semiconductor, MOS, device, the MOS device comprising a top side and a bottom side opposing the top side.

The separation of the source contact region, i.e., the first region of the current input electrode as defined above from the source channel region, i.e., the second region of the current input electrode as defined above has various advantages. The most important one is that for a MOS device with the self-aligned channel the small contacts can be fabricated on a flat wafer and that the full capability of the photolithography system can be used.

In an exemplary implementation of the method, the method comprises: forming a first mask layer above the JFET region; implanting the body region of the second semiconductor doping type in the drift layer by using the first mask layer; forming a spacer mask layer above part of the body region, the spacer mask layer contacting the first mask layer; implanting the second region of the current input electrode in the body region after the forming of the spacer mask layer; removal of the first mask layer and the spacer mask layer; patterning and implanting the first region and the body contact region prior to the forming the first mask layer; or patterning and implanting the first region and the body contact region after removal of the first mask layer and the spacer mask layer.

This provides the technical advantage that the separation of the current input electrode into the first region and the second region can be flexible manufactured, either by implanting of the first region and the body contact region prior to the forming the first mask layer; or by implanting of the first region and the body contact region after removal of the first mask layer and the spacer mask layer.

In an exemplary implementation of the method, implanting the second region of the current input electrode is co-implanting the implantation of the first region of the current input electrode and the body contact region.

This provides the technical advantage that the second region can be co-implanted with the implantation of the first region which improves manufacturing efficiency since only a single production step is required for production of both regions.

In an exemplary implementation of the method, implanting the second region of the current input electrode determines a length of the channel that is defined by a distance between a junction of the second region of the current input electrode to the body region and a junction of the body region to the JFET region.

### BRIEF DESCRIPTION OF THE DRAWINGS

Further embodiments of the disclosure will be described with respect to the following figures, in which:
Fig. 1a shows a design of a MOS device 100 according to an example of the disclosure with a lightly doped source 5b implantation shallower than a source contact 5a implantation;
Fig. 1b shows a design of a MOS device 100 according to an example of the disclosure with the lightly doped source 5b implantation deeper than the source contact 5a implantation;
Fig. 2a shows a design of a MOS device 100 according to an example of the disclosure with separation of the source into the source contact 5a and the lightly doped source 5b and different dopants used for both regions, a first dopant D1 of first doping type for region 5a and a second dopant D2 of first doping type for region 5b, for a case when region 5b is implanted at a shallower depth than region 5a;
Fig. 2b shows a design of a MOS device 100 according to an example of the disclosure with separation of the source into the source contact 5a and the lightly doped source 5b and different dopants used for both regions, a first dopant D1 of first doping type for region 5a and a second dopant D2 of first doping type for region 5b, for a case when region 5b is implanted at a bigger depth than region 5a;
Fig. 2c shows a design of a MOS device 100 according to an example of the disclosure with separation of the source into the source contact 5a and the lightly doped source 5b and over-etching the source contact region 5a where over-etching is smaller than the depth of region 5b;
Fig. 2d shows a design of a MOS device 100 according to an example of the disclosure with separation of the source into the source contact 5a and the lightly doped source 5b and over-etching the source contact region 5a where over-etching is bigger than the depth of region 5b;
Fig. 2e shows a design of a MOS device 100 according to an example of the disclosure with separation of the source into the source contact 5a and the lightly doped source 5b and over-etching the source contact region 5a where region 5b is implanted deeper than region 5a;
Fig. 3a shows a design of a MOS device 100 according to an example of the disclosure where the depletion region extends on both sides of a pn-junction, for a case of region 5b implanted shallower than region 5a;
Fig. 3b shows a design of a MOS device 100 according to an example of the disclosure where the depletion region extends on both sides of a pn-junction, for a case of region 5b implanted deeper than region 5a;
Fig. 3c shows a diagram 300 illustrating an effective channel length x₈(eff) (in micrometer) in dependence on a doping concentration of region 5b, N_{5b}, in cm⁻³ and the reduced effect of the decreased effective channel length, due to the depletion of the channel, at low doping concentrations of region 5b;
Fig. 4a shows a design of a first intermediate MOS device 101 after a first production step comprising deposition of the scattering oxide M0;
Fig. 4b shows a design of a second intermediate MOS device 102 after a second production step comprising implantation of the body contact 6 and the source contact 5a into a wafer with flat topography;
Fig. 4c shows a design of a third intermediate MOS device 103 after a third production step comprising processing of the first hard mask M1 used for the body region 4 implantation;
Fig. 4d shows a design of a fourth intermediate MOS device 104 after a fourth production step comprising creation of the spacer M2;
Fig. 4e-1 shows a design of a fifth intermediate MOS device 105 after a fifth production step comprising implantation of the lightly doped source 5b into the body 4 and the body contact 6 and the source contact 5a;

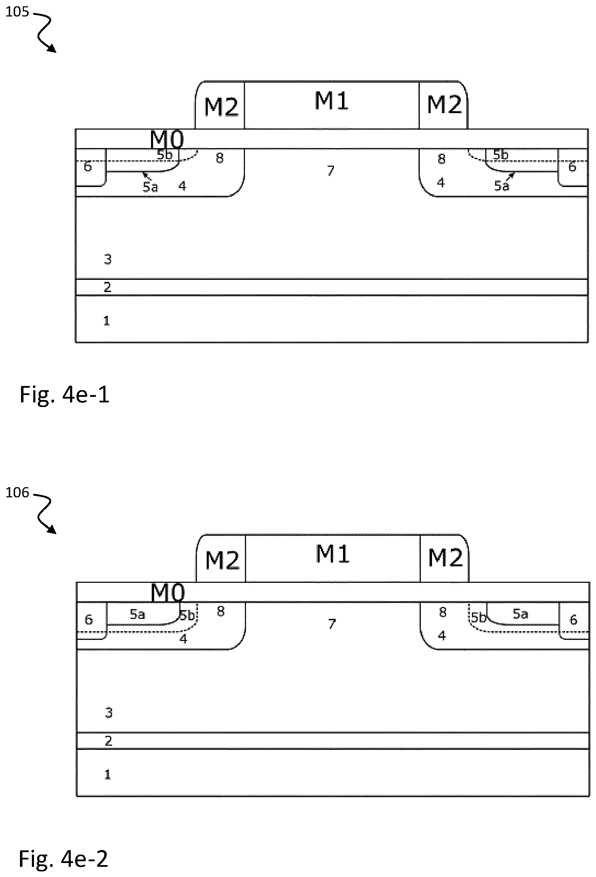

Fig. 4e-2 shows a design of a sixth intermediate MOS device 106 after the fifth production step shown in Figure 4e-1, where region 5b is implanted deeper than region 5a;

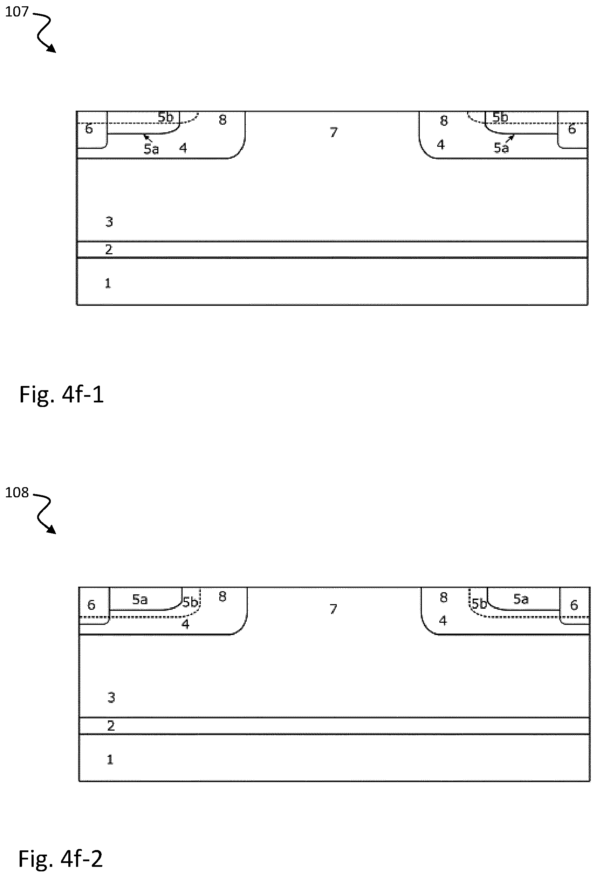

Fig. 4f-1 shows a design of a seventh intermediate MOS device 107 after removal of the hard masks;
Fig. 4f-2 shows a design of an eighth intermediate MOS device 108 after removal of the hard masks where region 5b is implanted deeper than region 5a;

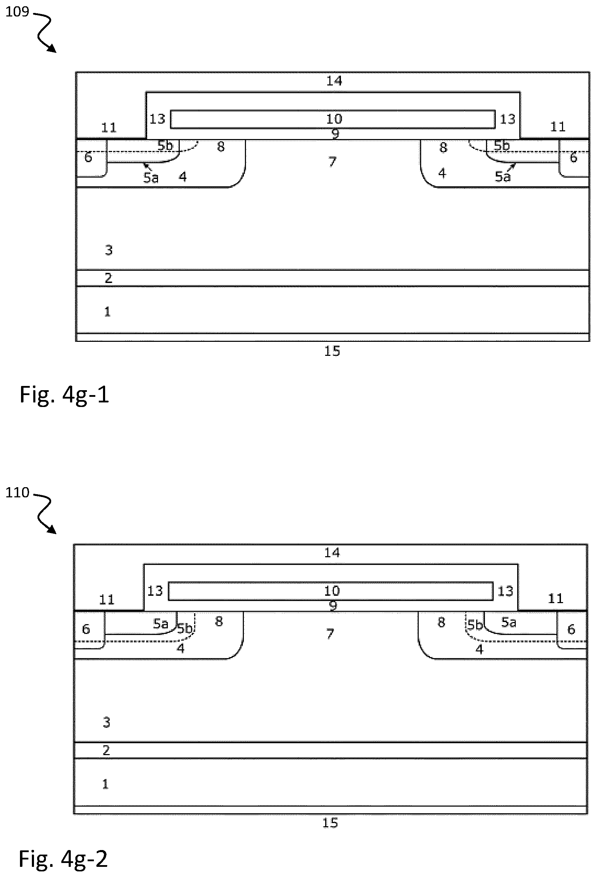

Fig. 4g-1 shows a design of a MOS device 109 at an end of the production process;
Fig. 4g-2 shows a design of a MOS device 110 at an end of the production process where region 5b is implanted deeper than region 5a;

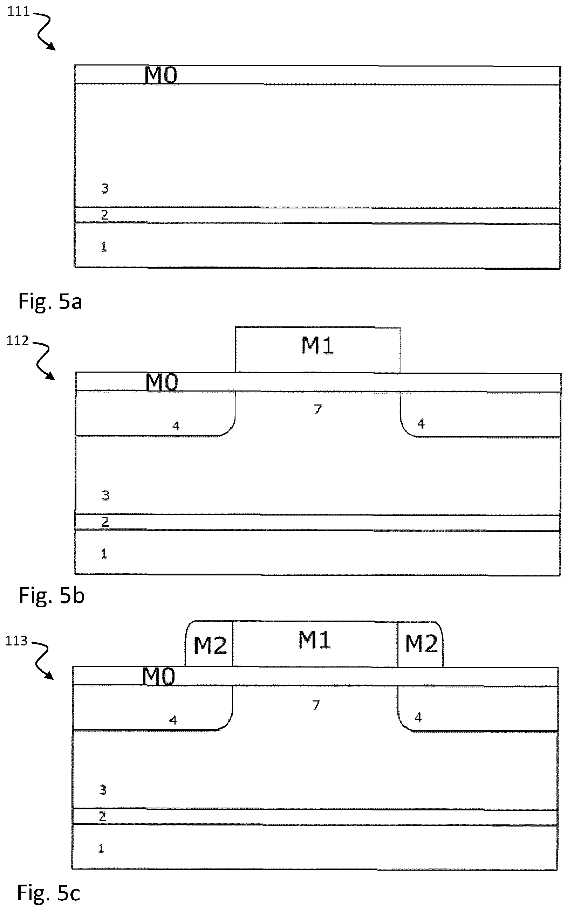

Fig. 5a shows a design of a first intermediate MOS device 111 after a first production step comprising deposition of the scattering oxide M0 where region 5a and region 6 are implanted after removal of the hard masks;
Fig. 5b shows a design of a second intermediate MOS device 112 after a second production step comprising processing of the first hard mask M1 used for the body region 4 implantation where region 5a and region 6 are implanted after removal of the hard masks;
Fig. 5c shows a design of a third intermediate MOS device 113 after a third production step comprising creation of the spacer M2 where region 5a and region 6 are implanted after removal of the hard masks;

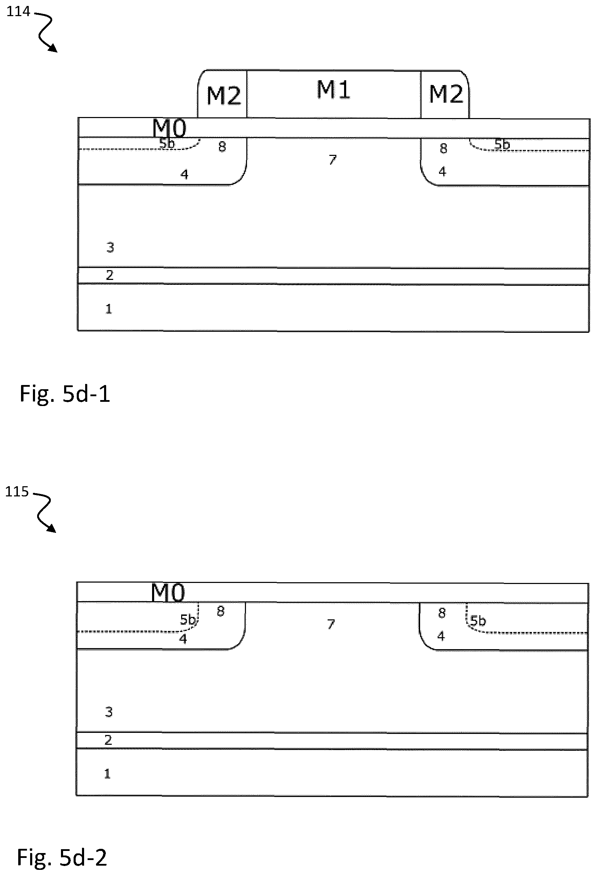

Fig. 5d-1 shows a design of a fourth intermediate MOS device 114 after a fourth production step comprising implantation of the lightly doped source 5b into the body 4 where region 5a and region 6 are implanted after removal of the hard masks;
Fig. 5d-2 shows a design of a fifth intermediate MOS device 115 after a fourth production step shown in Figure 5d-1, where region 5b is implanted deeper than region 5a and where region 5a and region 6 are implanted after removal of the hard masks;

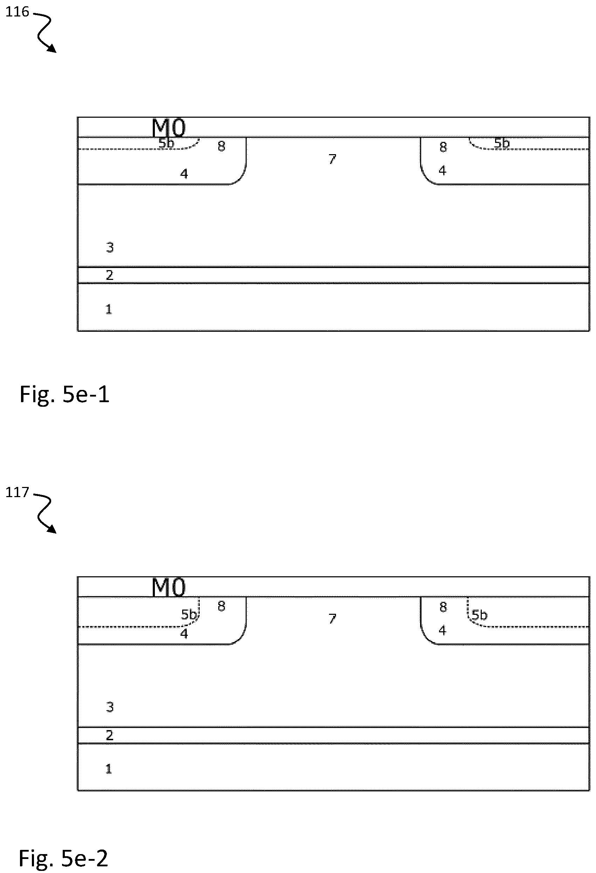

Fig. 5e-1 shows a design of a sixth intermediate MOS device 116 after the fifth production step, which is removal of the hard masks, where region 5a and region 6 are implanted after removal of the hard masks;
Fig. 5e-2 shows a design of a seventh intermediate MOS device 117 after the fifth production step, which is removal of the hard masks, where region 5b is implanted deeper than region 5a and where region 5a and region 6 are implanted after removal of the hard masks;

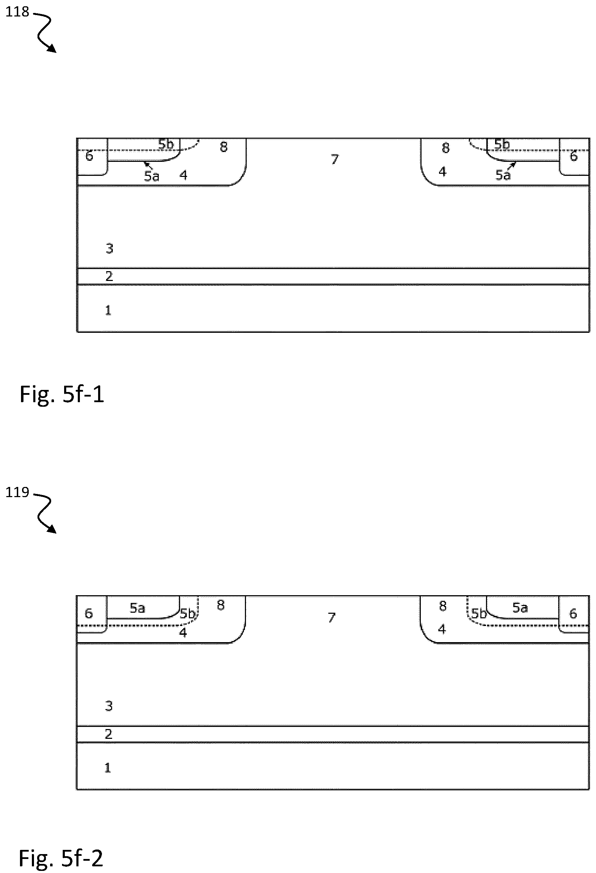

Fig. 5f-1 shows a design of an eighth intermediate MOS device 118 after the sixth production step comprising implantation of the body contact 6 and the source contact 5a into a wafer with flat topography where region 5a and region 6 are implanted after removal of the hard masks;

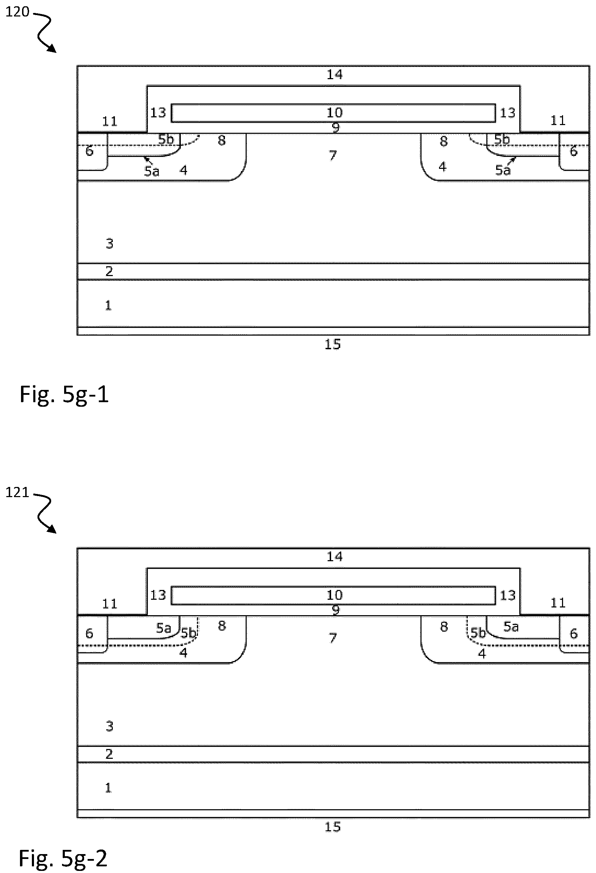

Fig. 5g-1 shows a design of a ninth intermediate MOS device 119 after the sixth production step comprising implantation of the body contact 6 and the source contact 5a into a wafer with flat topography where region 5b is implanted deeper than region 5a and where region 5a and region 6 are implanted after removal of the hard masks;
Fig. 5g-1 shows a design of a MOS device 120 at an end of the production process where region 5a and region 6 are implanted after removal of the hard masks;
Fig. 5g-2 shows a design of a MOS device 121 at an end of the production process where region 5b is implanted deeper than region 5a and where region 5a and region 6 are implanted after removal of the hard masks;

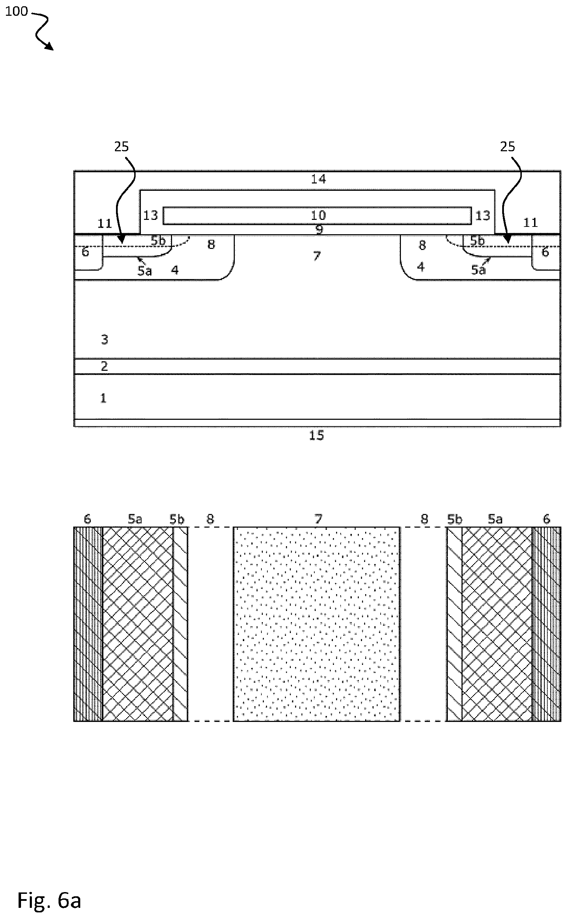

Fig. 6a shows a design of a MOS device 100 according to a comparative example where the body contact 6 and the source contact 5a are arranged parallel to the gate 10;

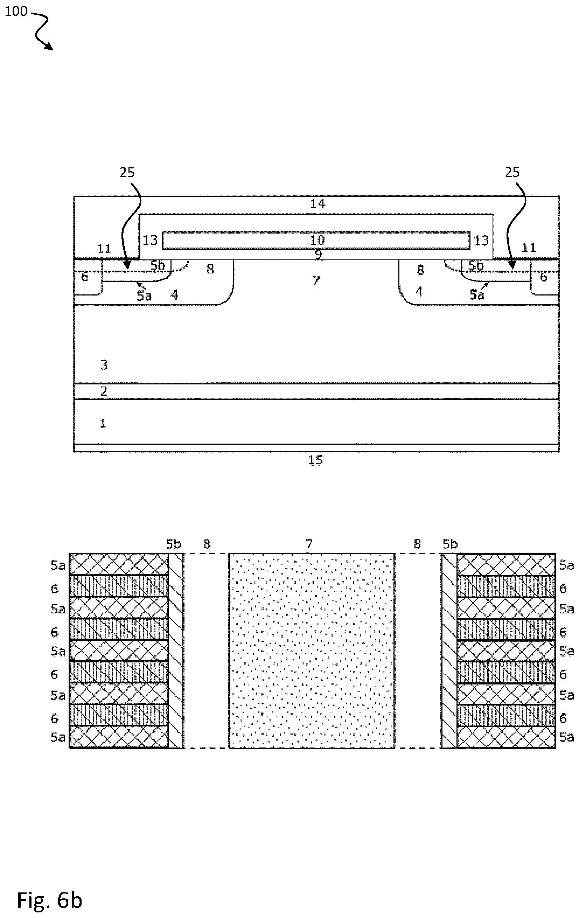

Fig. 6b shows a design of a MOS device 100 according to a comparative example with an alternate rectangular body contact 6 and a source contact 5a of the same length along the gate 10;

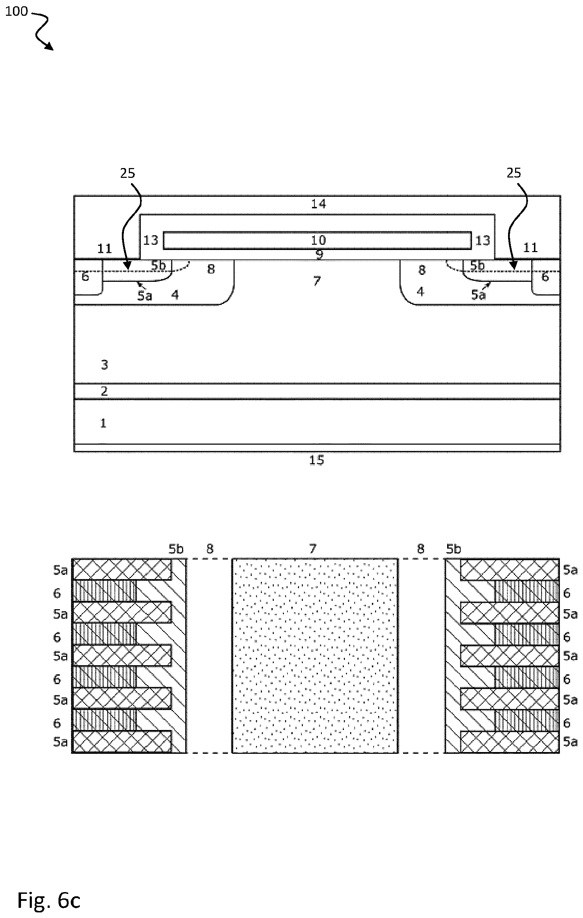

Fig. 6c shows a design of a MOS device 100 according to the invention with an alternate rectangular body contact 6 of a shorter length and a source contact 5a along the gate 10;

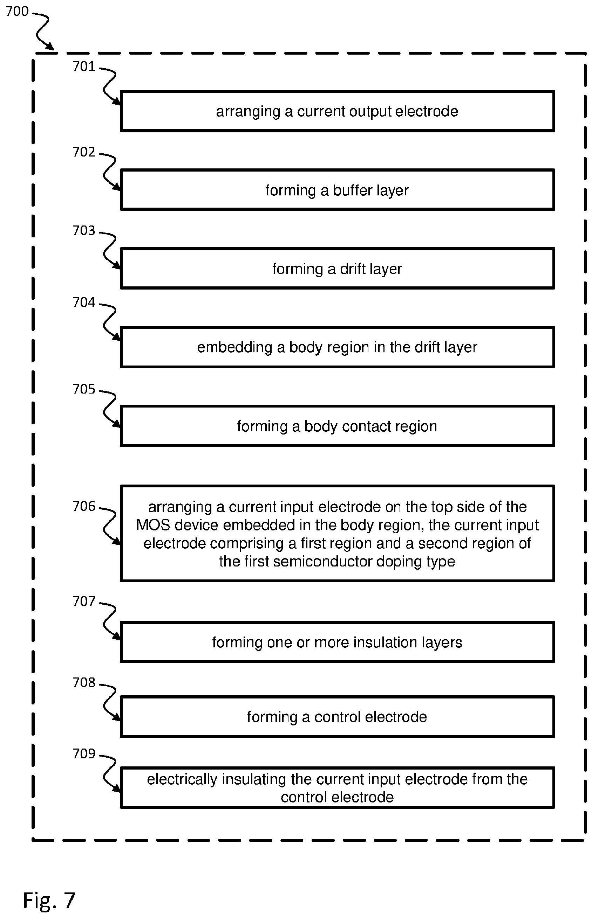

Fig. 7 shows a schematic diagram illustrating a method 700 for producing a MOS device 100 according to an example of the disclosure.

### DETAILED DESCRIPTION OF EMBODIMENTS

In the following detailed description, reference is made to the accompanying drawings, which form a part thereof, and in which is shown by way of illustration specific aspects in which the disclosure may be practiced. It is understood that other aspects may be utilized and structural or logical changes may be made without departing from the scope of the present disclosure. The following detailed description, therefore, is not to be taken in a limiting sense, and the scope of the present disclosure is defined by the appended claims.

It is understood that comments made in connection with a described method may also hold true for a corresponding device or system configured to perform the method and vice versa. For example, if a specific method step is described, a corresponding device may include a unit to perform the described method step, even if such unit is not explicitly described or illustrated in the figures. Further, it is understood that the features of the various exemplary aspects described herein may be combined with each other, unless specifically noted otherwise.

The MOS devices described herein may be implemented in various applications, e.g. in power conversion devices for automotive and industrial applications, for example. The described MOS devices may be applied in integrated circuits and/or power semiconductors and may be manufactured according to various technologies. For example, the MOS devices may be utilized in logic integrated circuits, analog integrated circuits, mixed signal integrated circuits, optical circuits, memory circuits and/or integrated passives.

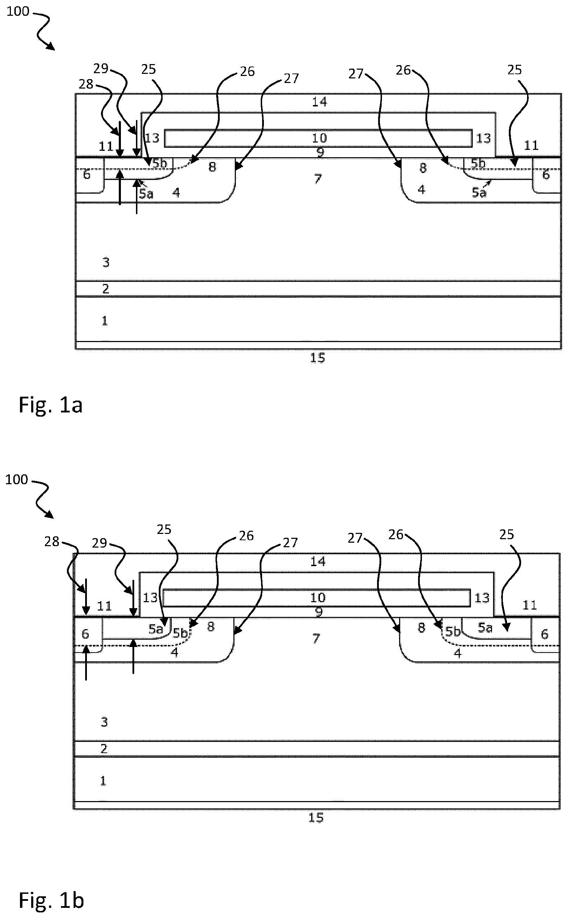

Fig. 1a shows a design of a MOS device 100 according to the disclosure with a lightly doped source 5b implantation shallower than a source contact 5a implantation.

The MOS device 100 comprises a control electrode 10 arranged on a top side of the MOS device 100. The MOS device 100 comprises a current output electrode 1 of a first semiconductor doping type or of a second semiconductor doping type. The current output electrode 1 is arranged on a bottom side of the MOS device 100 which bottom side opposes the top side. The MOS device 100 comprises a buffer layer 2 of the first semiconductor doping type formed above the current output electrode 1 and a drift layer 3 of the first semiconductor doping type formed above the buffer layer 2. The MOS device 100 comprises a body region 4 of the second semiconductor doping type, embedded in the drift layer 3, the body region 4 configured to form a Junction Field Effect Transistor, JFET, region 7 in the drift layer 3 below the control electrode 10.

The MOS device 100 comprises a current input electrode 25 comprising a first region 5a and a second region 5b of the first semiconductor doping type embedded in the body region 4. The current input electrode 25 is configured to be electrically insulated from the control electrode 10 by one or more insulation layers 9, 13. A channel 8 of the MOS device 100 is configured to be formed between a junction 26 of the second region 5b of the current input electrode 25 to the body region 4 and a junction 27 of the body region 4 to the JFET region 7.

The MOS device 100 has a top side and a bottom side opposing the top side. Top side and bottom side correspond to top side and bottom side represented in the figures. The top side is the side where the source and drain connectors, i.e., current input electrode 25 and current output electrode 1 according to the above terminology can be functionally influenced, e.g., by the gate connector, i.e., the control electrode 10 according to the above terminology. The bottom side is the side where drain connector, i.e., current output electrode 1 according to the above terminology is located.

The current output electrode 1 is in connection with a metal layer 15 which forms a metallization of the current output electrode 1. The current output electrode 1 is also in connection with the buffer layer 2.

The MOS device 100 forms a vertical device where the current output electrode 1, the buffer layer 2, the drift layer 3, the JFET region 7, the insulation layers 9, 13 and the control electrode 10 are aligned in vertical direction. Body region 4 and JFET region 7 are laterally arranged with respect to each other. The current output electrode 1 with its metallization 15 forms the bottom of the vertical device and the control output electrode 1 with insulation layer 9, 13 and metallization 14 forms the top of the vertical device. In the MOS device 100, buffer layer 2 is in vertical direction in contact with current output electrode 1; drift layer 3 is in vertical direction in contact with buffer layer 2; JFET region 7 is formed in drift layer 3 in vertical direction contacting insulation layer 9, 13; control electrode is in vertical direction in contact with insulation layer 9, 13.

In the figures, current input electrode is referred to by reference sign 25. This current input electrode 25 includes both, the first region referred to by reference sign 5a and the second region referred to by reference sign 5b.

The buffer layer 2 is a first deposited layer. The drift layer 3 is a second deposited layer. Note that the device is not limited to these two layers, i.e., buffer layer 2 and drift layer 3. It understands that even more layers can be deposited. Particularly, the drift layer 3 can be decomposed into few layers 3a, 3b, 3c, ... which have different functions. In other words, there are basically two layers (layer 2 and layer 3) but the number of layers is not limited to 2. There may be other layer having another function than the drift layer and the buffer layer, e.g., a recombination-enhancement layer, a current spreading layer, etc.

Both layers 9 and 13 are insulation layers, but they may be fabricated in independent steps. Layer 9 can be the gate oxide - a part of the MOS structure. Layer 13 can be the interlayer dielectric which separates control electrode 10, e.g., polysilicon gate 10 from metallization 14 of current input electrode, e.g., source metal 14.

As defined above, the body region 4 is forming the JFET region 7 in the drift layer 3 below the control electrode 10. There is no separate process which forms the JFET region 7. JFET region 7 may be seen as a side-effect of the body formation and it may be created between the body regions as shown in Figures 1a and 1b.

As shown in Figure 1a, the MOS device 100 may comprise a body contact region 6 of the second semiconductor doping type electrically contacting the body region 4. The body contact region 6 is configured to electrically contact the current input electrode 25.

The body contact region 6 is electrically contacting the body region 4. In one example configuration the body contact region 6 may be placed outside of the cell and can be orthogonal to the cell. Then, the body contact region 6 is not embedded in the body region 4, but it just contacts the body region 4 at some locations.

A semiconductor doping concentration of the second region 5b of the current input electrode 25 may be lower than a semiconductor doping concentration of the body contact region 6.

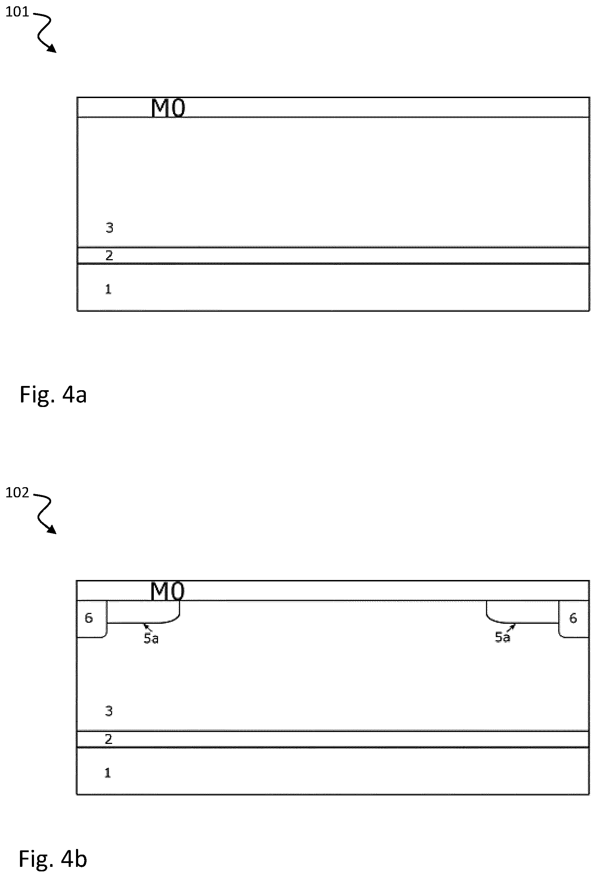

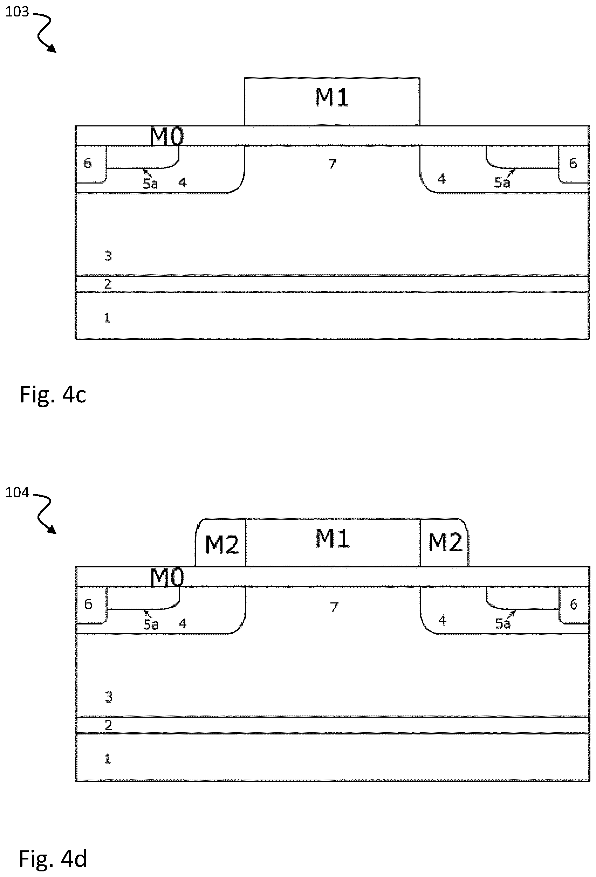

This feature enables a co-implantation of the second region 5b of the current input electrode 25 into the body contact region 6 during a production of the MOS device without significant doping compensation of the body contact region 6 and hence avoids an additional masking of the body contact region 6, e.g., as described below with respect to Figures 4 and 5.

In the MOS device 100 shown in Figure 1a, a length of the channel 8 can be defined by a distance between the junction 26 of the second region 5b of the current input electrode 25 to the body region 4 and the junction 27 of the body region 4 to the JFET region 7.

The first region 5a of the current input electrode 25 and the second region 5b of the current input electrode 25 may comprise different ion implantations, particularly different dopant atoms of the same doping type.

For a SiC semiconductor device as an example, typical values for the peak doping concentration N are for example for the first region 5a: N=1e19 cm⁻³ to 1e20 cm⁻³ and for the second region 5b: N=1e17 cm⁻³ to 1e19 cm⁻³.

As shown in the MOS device 100 of Figure 1a, a depth 28 of the second region 5b of the current input electrode 25 can be smaller than a depth 29 of the first region 5a.

In an alternative implementation of the MOS device 100 as shown in Figure 1b, a depth 28 of the second region 5b of the current input electrode 25 can be bigger than a depth 29 of the first region 5a.

In an exemplary implementation of the MOS device 100 not shown in Figures 1a and 1b, the body contact region 6 can be configured to extend through the body region 4 into the drift layer 3.

In the MOS device 100, the semiconductor doping concentration of the first region 5a of the current input electrode 25 can for example be within a same range of a semiconductor doping concentration of the body contact region 6.

For a SiC semiconductor device as an example, the semiconductor doping concentration of the first region 5a may be for example in a range of: N= 1e19 cm⁻³ to 1e20 cm⁻³. The semiconductor doping concentration of the body contact region 6 may be for example in a range of: N=5e18 cm⁻³ to 1e20 cm⁻³. This range specifies the range of heavy doping at the contacts.

In the MOS device 100, the semiconductor doping concentration of the second region 5b of the current input electrode 25 may be for example at least one order of magnitude lower than a semiconductor doping concentration of the first region 5a of the current input electrode 25.

For a SiC semiconductor device as an example, the semiconductor doping concentration of the first region 5a may be for example in a range of: N=1e19 cm⁻³ to 1e20 cm⁻³. The semiconductor doping concentration of the second region 5b may be for example in a range of: N=1e17 cm⁻³ to 1e19 cm⁻³.

The MOS device 100 may comprise or may be a MOSFET transistor with a gate electrode corresponding to the control electrode 10, a source electrode corresponding to the current input electrode 25 and a drain electrode corresponding to the current output electrode 1.

The MOS device 100 may comprise or may be an IGBT transistor with a gate electrode corresponding to the control electrode 10, an emitter electrode corresponding to the current input electrode 25 and a collector electrode corresponding to the current output electrode 1.

The channel 8 of the MOS device 100 can be a self-aligned channel 8 that may be defined by a distance between the junction of the second region 5b of the current input electrode 25 to the body region 4 and the junction of the body region 4 to the JFET region 7.

The current input electrode 25 of the MOS device 100 may be shaped according to a step profile, e.g. as shown in Figure 1a.

The current input electrode 25 of the MOS device 100 may comprise two semiconductor doping concentrations of the first semiconductor doping type. The second region 5b may extend the first region 5a in both vertical and lateral direction, e.g. as shown in Figure 1b.

The MOS device 100 may comprise or may be implemented as a Silicon Carbide power semiconductor device.

Implementation of the MOS device 100 as a silicon carbide power semiconductor device provides various advantages, such as: Wide-bandgap, resulting in high maximum electric field and stable operation in wide-temperature range due to low intrinsic carrier density; High critical electric field, resulting in thinner and higher doped device drift layer and finally in lower device resistance; High thermal conductivity, resulting in excellent heat dissipation and finally in simple or no device cooling system; High drift electron velocity, resulting in high electron mobility at high electric fields and finally in low device resistance and fast switching; Small application weight and volume due to the above properties.

As shown in Figures 1a and 1b, the control electrode 10 may be configured to overlap or at least partially overlap the second region 5b of the current input electrode 25.

This feature has the technical effect that the overlap between control electrode 10 such as gate and second region of the current input electrode 5b, which is lightly doped source, determines the gate-source capacitance which has the impact on switching of the device. Switching means both switching on and switching off.

A length of the channel 8 shown in the MOS device 100 of Figure 1a and Figure 1b may be based on the semiconductor doping concentration of the second region 5b of the current input electrode 25.

The effective length of the channel, i.e. the final length of the channel, is specified by the length of the channel reduced by the total depletion layer length in the channel.

The MOS device 100 may further comprise an input contact metallization 11 spreading over the body contact region 6 and a part of the current input electrode 25. A thickness of the first region 5a of the current input electrode 25 below the input contact metallization 11 may be smaller than a thickness of the first region 5a of the current input electrode 25 outside the input contact metallization 11.

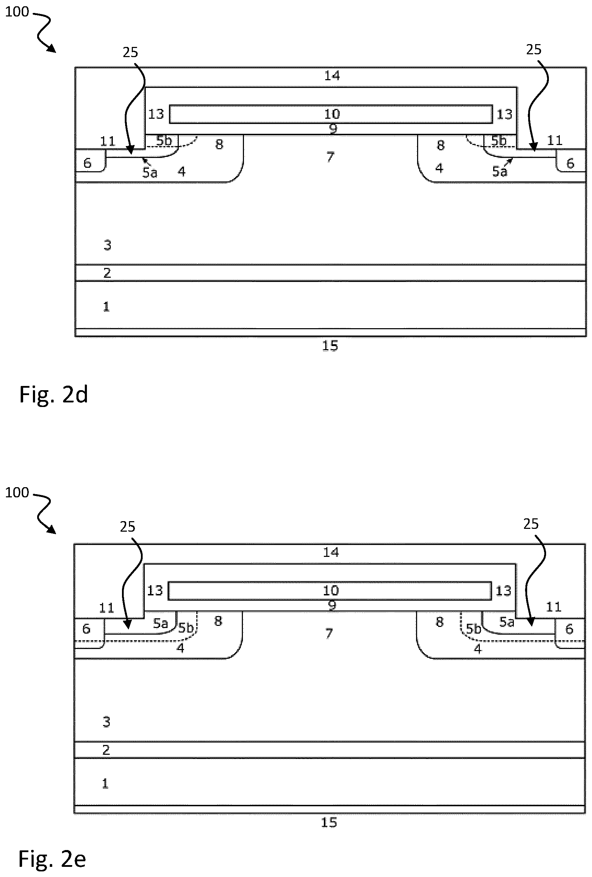

This thinner part of the first region 5a of the current input electrode 25 may result from over-etching the current input electrode 25, e.g., as shown in Figures 2c, 2d, 2e. By this over-etching, only the current input electrode 25 region below the input contact metallization 11 is influenced, i.e., the parameters of the channel region 8/5b, particularly the channel depth, do not require any change due to intentional or foreseen uncontrolled over-etching in the first region 5a of the current input electrode 25.

Fig. 1b shows a design of a MOS device 100 according to the disclosure with the lightly doped source 5b implantation deeper than the source contact 5a implantation.

The MOS device 100 of Figure 1b corresponds to the MOS device 100 described above with respect to Figure 1a.

I.e., the MOS device 100 of Figure 1b comprises a control electrode 10 arranged on a top side of the MOS device 100. The MOS device 100 comprises a current output electrode 1 of a first semiconductor doping type or of a second semiconductor doping type. The current output electrode 1 is arranged on a bottom side of the MOS device 100 which bottom side opposes the top side. The MOS device 100 comprises a buffer layer 2 of the first semiconductor doping type formed above the current output electrode 1 and a drift layer 3 of the first semiconductor doping type formed above the buffer layer 2. The MOS device 100 comprises a body region 4 of the second semiconductor doping type, embedded in the drift layer 3, the body region 4 configured to form a Junction Field Effect Transistor, JFET, region 7 in the drift layer 3 below the control electrode 10.

The MOS device 100 of Figure 1b comprises a current input electrode 25 comprising a first region 5a and a second region 5b of the first semiconductor doping type embedded in the body region 4. The current input electrode 25 is configured to be electrically insulated from the control electrode 10 by one or more insulation layers 9, 13. A channel 8 of the MOS device 100 is configured to be formed between a junction 26 of the second region 5b of the current input electrode 25 to the body region 4 and a junction 27 of the body region 4 to the JFET region 7.

One difference to the MOS device shown in Figure 1b to the MOS device shown in Figure 1a is that the depth 28 of the second region 5b of the current input electrode 25 can be bigger than the depth 29 of the first region 5a.

Figures 1a and 1b thus represent the basic structure of a SiC Power MOSFET. The vertical device 100 consists of the substrate for current output electrode 1, the buffer layer 2 and the drift layer 3 or drift region of first doping type, the body region(s) 4 of second doping type, the source region comprising first region 5a and second region 5b of first doping type and the body contact region 6 of second doping type.

The region between the body regions 4 is called the JFET region 7 and it can be additionally implanted with ions of first doping type. The region between the JFET region 7 and the source region 5a/5b in a close proximity of the surface is called the channel 8. The gate can be formed on the top of drift layer 3 as a SiO2 (9) / polysilicon (10) stack and it may spread over the JFET 7 and channel 8 regions and may overlap the source region 5a/5b.

The active contact 11 may spread over the body contact region 6 and a part of the source region 5a/5b called the source contact. The gate 10 can be separated from the active contact 11 by the interlayer dielectric 13. The front side can be covered with the metal 14 which connects the active contact 11 (so called SOURCE pad) and which can be separated from the gate 10 by the interlayer dielectric 13.

Outside of the active area of the device the gate 10 can be connected with the metal 14 and separated from SOURCE (so called GATE pad, not presented in the figures). The backside or bottom side as defined above can be metallized with the metal 15. Additional passivation layers on the front side or top side as defined above can be implemented (not presented in the figures).

A basic design concept of the MOS device 100 shown in Figures 1a and 1b is the separation of the source region into two independent parts, which are: 1) the source contact, defined herein as first region 5a of current input electrode 25; and 2) a lightly doped source, defined herein as second region 5b of current input electrode 25.

The source contact 5a can be patterned and implanted prior to a first hard mask M1 fabrication as shown in Figure 4 or after the hard mask M1/M2 removal as shown in Figure 5. The function of the source contact 5a is to provide the low-ohmic access to the lightly doped source. Similarly, the body contact region 6 can be patterned and implanted prior to the first hard mask M1 fabrication or after the hard mask M1/M2 removal as shown in Figures 4 and 5. The lightly doped source 5b can be implanted within the self-aligned channel process after creation of the spacer M2. The function of the lightly doped source 5b is to achieve the self-alignment of the channel. The lightly doped source 5b can be co-implanted into the body contact region 6 of opposite doping type, but because of the significantly lower doping concentration of the lightly doped source 5b the doping concentration of the body contact region 6 is almost not compensated. The contact function (source contact 5a) and the channel definition function (lightly doped source 5b) of the source region are separated from each other in the presented solution.

Figures 1a and 1b present two examples of a final SiC planar-gate MOSFET structure for the lightly doped source 5b implantation shallower and deeper than the source contact 5a implantation, respectively.

The design concept shown in Figures 1a and 1b can also be applied to other SiC devices having the channel, for example to SiC IGBT. The design can also be extended to other technologies, for example to silicon devices. The SiC planar-gate MOSFET is currently available on n-type substrate 1 doped with nitrogen. In such case, the buffer layer 2 and the drift layer 3 and the source region 5a/5b can be either of the n-type doping, while the body region 4 and the body contact region 6 and the created channel 8 can be of the p-type doping and may be doped with aluminum.

The MOS device 100 shown in Figures 1a and 1b provides the following advantages:
The self-aligned channel process as defined by the body region 4 and the lightly doped source 5b can be used for fabrication of a SiC MOS device, which allows for smaller elementary cell pitch and resulting larger cell integration density and resulting lower device resistance.

Small feature size source contact 5a and body contact region 6 can be patterned on a relatively flat wafer prior to the hard mask fabrication or after the hard mask removal. The flat topography allows for using full capability of the photolithography system and reduces the depth of focus issues. The manufacturability and process reliability are improved.

The source can be separated into the source contact, i.e., first region 5a and the lightly doped source, i.e., second region 5b, hence some properties of the source contact 5a and the lightly doped source 5b can be different, e.g. different doping species can be used for both regions and the ions can be implanted at different depths and the active contact region 11 can be over-etched by dry etching without introducing any change into the channel region 8/5b as shown in Figures 2c to 2e.

The lightly doped source 5b in the proximity of the channel 8 causes that the depletion region in the channel becomes narrower and the depletion region in the source (here in the lightly doped source) becomes wider, as presented in Figures 3a and 3b, which reduces the effect of decreased effective channel length and helps better control the channel length 8, which is especially important for the channels in the submicron range.

A basic aspect of the disclosed MOS device 100 presented herein is the separation of the source contact region 5a from the source channel region, i.e., the lightly doped source 5b, where the first region 5a is produced prior to or after the self-aligned channel process and the second region 5b is produced within the self-aligned channel process.

The separation of the source contact region 5a from the source channel region 5b has various benefits, which have been pointed out above. The most important one is that for a device with the self-aligned channel the small contacts can be fabricated on a flat wafer and that the full capability of the photolithography system can be used. This can be seen as a big improvement compared to the photolithography processing on a wafer with extreme high-low topography, i.e. hard masks M1/M2 needed to produce another mask M3.

In addition, that separation allows for defining the independent properties of the source contact 5a and the lightly doped source 5b. Different species of the same doping type can be used for the source contact 5a and lightly doped source 5b implantations as shown in Fig. 2a.

For example, for n-type SiC MOSFET or IGBT the source contact 5a can be implanted with nitrogen and the lightly doped source can be implanted with phosphorus, or vice versa. This provides an advantage if one ion offers more benefits than the other in terms of increase of the channel mobility or decrease of the contact resistance.

Moreover, the separation of the regions means that the ions can be implanted with different parameters, i.e. with different implantation energies and doses. Particularly, the implantation depth of the lightly doped source 5b can be smaller or bigger than the implantation depth of the source contact 5a. Because it can be assumed that the doping concentration of the lightly doped source 5b is lower than the doping concentration of the source contact 5a, both implantations can be recognized in the SEM/FIB cross-section of the device, for instance as shown in Figs. 1a and 1b, even if the same implantation energies are used.

The visibility of two implantations used for the source region, i.e. regions 5a and 5b, instead of just one region differentiates the disclosed MOS device 100 from other devices of the same type. In addition, the ability of using different implantation parameters and having different depths for both regions results in a wider process window for some other steps.

Particularly, the benefit can be seen when the active contact region 11 is over-etched during the ohmic contact fabrication as displayed in Fig. 2c. In this particular case, the depth of the source contact 5a can be made bigger than the depth of the lightly doped source 5b in order to compensate the effect of the over-etching of the contacts, but the channel 8 properties determined by the lightly doped source 5b will not change.

The over-etching of the active contact region 11 can be also done by purpose in depths bigger than the depth of the lightly doped source 5b. By doing that, the lightly doped source 5b dopants can be removed from the source contact 5a and the body contact 6 regions and the lightly doped source 5b process step has no effect on the contact electrical properties, although that effect should be normally negligible due to the difference in the doping levels, as already discussed.

Fig. 2a shows a design of a MOS device 100 according to the disclosure with separation of the source into the source contact 5a and the lightly doped source 5b and different dopants used for both regions, a first dopant D1 of first doping type for region 5a and a second dopant D2 of first doping type for region 5b, for a case when region 5b is implanted at depth D2 shallower than depth D1 of region 5a.

The MOS device 100 of Figure 2a may correspond to the MOS device 100 described above with respect to Figures 1a and 1b.

The source contact can be separated into the source contact 5a, i.e., the first region 5a of the current input electrode 25, and the lightly doped source 5b, i.e. the second region 5b of the current input electrode 25.

A first dopant of first doping type may be used for the first region 5a, and a second dopant of first doping type may be used for the second region 5b.

The current input electrode 25 of the MOS device 100 shown in Figure 2a is shaped according to a step profile. The edges of the two steps shown in Figure 2a are rounded or flattened.

Fig. 2b shows a design of a MOS device 100 according to the disclosure with separation of the source into the source contact 5a and the lightly doped source 5b and different dopants used for both regions, a first dopant D1 of first doping type for region 5a and a second dopant D2 of first doping type for region 5b, for a case when region 5b is implanted at depth D2 bigger than depth D1 of region 5a.

The MOS device 100 of Figure 2b corresponds to the MOS device 100 shown in Figure 2a, but the second region 5b is implanted deeper than the first region 5a.

Fig. 2c shows a design of a MOS device 100 according to the disclosure with separation of the source into the source contact 5a and the lightly doped source 5b and over-etching the source contact region 5a where over-etching is smaller than the depth of region 5b.

The MOS device 100 of Figure 2c may correspond to the MOS device 100 described above with respect to Figures 1a and 1b but in the MOS device 100 of Figure 2c over-etching is applied.

The source contact region, i.e., the first region 5a of the current input electrode 25 can be over-etched without introducing any change into the channel region 8/5b.

In the MOS device 100 of Figure 2c, over-etching is smaller than the depth of the second region 5b.

Fig. 2d shows a design of a MOS device 100 according to the disclosure with separation of the source into the source contact 5a and the lightly doped source 5b and over-etching the source contact region 5a where over-etching is bigger than the depth of region 5b.

The MOS device 100 of Figure 2d corresponds to the MOS device 100 shown in Figure 2c, but over-etching is bigger than the depth of the second region 5b.

Fig. 2e shows a design of a MOS device 100 according to the disclosure with separation of the source into the source contact 5a and the lightly doped source 5b and over-etching the source contact region 5a where region 5b is implanted deeper than region 5a.

The MOS device 100 of Figure 2e corresponds to the MOS device 100 shown in Figure 2c, but the second region 5b is implanted deeper than the first region 5a.

Fig. 3a shows a design of a MOS device 100 according to the disclosure where the depletion region extends on both sides of a pn-junction and is the wider the lower is the doping, for a case of region 5b implanted shallower than region 5a.

The MOS device 100 of Figure 3a may correspond to the MOS device 100 described above with respect to Figures 1a and 1b.

The depletion region, marked by the dashed lines, extends on both sides of a pn-junction between the current input electrode 25 and the body region 4, and is the wider the lower is the doping. By the introduction of the lightly doped source 5b the depletion region extends more in the lightly doped source 5b than in the channel 8 and the effective channel length is closer to the designed value.

Fig. 3b shows a design of a MOS device 100 according to the disclosure where the depletion region extends on both sides of a pn-junction and is the wider the lower is the doping, for a case of region 5b implanted deeper than region 5a.

The MOS device 100 of Figure 3b corresponds to the MOS device 100 shown in Figure 3a, but the second region 5b is implanted deeper than the first region 5a.

Fig. 3c shows a diagram 300 illustrating an effective channel length x₈(eff) (in micrometer) in dependence on a doping concentration of region 5b, N_{5b}, in cm⁻³ and the reduced effect of the decreased effective channel length, due to the depletion of the channel, at low doping concentrations of region 5b.

An exemplary number of three values 301, 302, 303 are shown which illustrate the non-linear behavior of the effective channel length X₈(eff) versus the doping concentration N_{5b}.

The effective channel length can be modulated by using doping. As described above with respect to Figures 3a and 3b, the depletion region, marked by the dashed lines, extends on both sides of a pn-junction between the current input electrode 25 and the body region 4, and is the wider the lower is the doping. By the introduction of the lightly doped source 5b the depletion region extends more in the lightly doped source 5b than in the channel 8 and the effective channel length is closer to the designed value.

Figures 4a to 4g-2 and Figures 5a to 5g-2 describe a fabrication process flow for the MOS device 100 described above with respect to Figures 1 to 3. Different intermediate devices 101, 102, 103, 104, 105, 106, 107, 108, 109, 110 are produced in the respective production steps shown in these figures.

The fabrication process is shown for a case of the body contact region 6 and the source contact 5a, i.e., first region 5a of current input electrode 25, patterned prior to the hard mask (M1/M2) fabrication, but those contacts can be fabricated after the self-aligned channel process and the hard mask removal with the same effect for the device. Those small contacts may be fabricated on a flat surface not directly within the self-aligned channel process but prior to it or after it.

After the initial process steps not discussed herein, i.e., manufacturing the current output electrode 1, the buffer layer 2 on top of the current output electrode 1 and the drift layer 3 on top of the buffer layer 2, the first relevant process step is the deposition of the scattering oxide M0 onto the front side of the wafer, i.e., on top of the drift layer 3, as presented in Figure 4a.

This kind of process is a standard process in semiconductor technology. Main functions of the scattering oxide are the following: a) to scatter the implanted ions in order to minimize the effects of ion channeling; b) to set the peak concentration of implanted profiles on the surface; and c) to protect the surface from over-etching during the subsequent steps.

In addition, in some cases the oxide can act as a stop layer for dry etching processes with high selectivity ratio or with the end point detection. The oxide mask may have a typical thickness ranging from ten nanometers to few hundreds of nanometers.

The next step is the photolithography and ion implantation for the body contact region 6 and the source contact 5a as presented in Fig. 4b. Because the topography is flat, i.e. thin oxide on wafer, full capability of the photolithography system can be used and the smallest specified feature size can be achieved.

The source and body contacts are implanted: a) either through patterned photoresist close to room temperature; or b) through patterned hard masks, e.g., oxide, close to room or elevated temperatures.

In case the oxide mask M0 is removed from the surface during removal of the aforementioned hard masks, the oxide mask M0 can be deposited again. The overlay between the body contact region 6 and the source contact 5a can have an arbitrary value, but usually the smallest possible overlay, that is nearly adjacent contacts, may be demanded.

Subsequently, the first hard mask layer of the self-aligned channel process can be deposited onto the front side of the wafer. The layer can be patterned using the photolithography and dry etching, where the oxide mask M0 acts as a stop and surface protection layer.

In this way the first mask M1 used for the body region 4 implantation can be created as displayed in Fig. 4c. The alignment of the source contact 5a on the body region 4 is not critical due to the lightly doped source 5b produced in next steps within the self-aligned channel process.

The primary material used for the hard mask M1 can be the un-doped polysilicon, but other materials available in the fab can be used as well. In case of the polysilicon, the mask M1 may have a thickness of at least 1.2 um (micrometers) in order to block the body region 4 dopants, e.g., aluminum, implanted at typical depths.

The photoresist mask can be left or removed from the hard mask M1 prior to the body region ion implantation. If the photoresist is left, the ions can be implanted close to room temperatures. If the photoresist is removed, the ions can be implanted at higher temperatures, e.g., at 500-600 °C.

The next step is the deposition of the second layer of the self-aligned channel process onto the surface of the wafer. The process can be performed by chemical vapor deposition (CVD), in order to guarantee good coverage of the first hard mask M1. Particularly, there can be good conformance between the layer thickness on the sidewalls and the mesa of the first mask M1 and on the wafer surface between the first hard mask M1 pillars.

The primary materials used for the second layer may be silicon nitride or silicon dioxide. The second layer can be etched by dry etching in entire active area of the device, which results in creation of the spacer as displayed in Fig. 4d. The width of the spacer can be roughly equal to the thickness of the deposited CVD layer.

The lightly doped source 5b can be implanted through the hard masks M1/M2 as shown in Fig. 4e-1. The lightly doped source 5b can be implanted into the body region 4 and creates the self-aligned channel 8 whose length can be defined by the spacer width. It can also be implanted into the body contact region 6 and the source contact 5a, but because of its significantly lower doping the doping of the source contact 5a can be hardly increased and the doping of the body contact 6 can be hardly compensated.

Typically, the peak doping concentration (N) of the contacts 5a/6 and the lightly doped source 5b for an n-type SiC MOSFET or IGBT can be in the range of:
i) Body contact region 6, N_{AI} = 1e19 cm⁻³ to 1e20 cm⁻³; ii) Source contact 5a, N_{N} = 1e19 cm⁻³ to 1e20 cm⁻³; and iii) Lightly doped source 5b, N_{N} = 1e17 cm⁻³ to 1e19 cm⁻³.

After the lightly doped source 5b implantation the hard masks M0/M1/M2 can be removed, e.g., by wet etching, and the fabrication process may continue as shown in Figures 4f-1, 4f-2, 4g-1 and 4g-2. As previously mentioned, the source contact 5a and the body contact 6 can be either produced after the self-aligned channel process, i.e., lightly doped source 5b, and after the hard mask removal instead of being fabricated prior to it.

Fig. 4f-1 shows a production step design 107 after removal of the hard masks. Fig. 4f-2 shows a production step design 108 after removal of the hard masks where region 5b is implanted deeper than region 5a. Fig. 4g-1 shows a production step design 109 at an end of the production process. Fig. 4g-2 shows a production step design 110 at an end of the production process where region 5b is implanted deeper than region 5a.

Figures 5a to 5g-2 show the same process steps as Figures 4a to 4g-2, but for region 5a and region 6 implanted after removal of the hard masks.

Figures 6a, 6b show different designs of a MOS device 100 according to comparative examples with different arrangements of the body contact region 6 and a source contact 5a. Figure 6c shows a design of a MOS device 100 according to the invention with a different arrangement of the body contact region 6 and a source contact 5a. In Figure 6a, the body contact 6 and the source contact 5a may be arranged parallel to the gate 10. In Figure 6b, an alternate rectangular body contact 6 and the source contact 5a of the same length may be arranged along the gate 10. In Figure 6c, an alternate rectangular body contact 6 of a shorter length and a source contact 5a are arranged along the gate 10. The lightly doped source 5b is marked in the figures with negative-slope stripes.

The MOS devices 100 of Figures 6a and 6b and 6c may correspond to the MOS device 100 shown in Figures 1a and 1b, where a contact arrangement can be different.

The body contact region 6 and the source contact can be arranged in various ways: 1) The contacts can have a stripe shape and can be parallel to the stripe gate as shown in Figure 6a; 2) The contacts can be made as plurality of rectangular fields of the same size and alternate doping, for example as square fields as shown in Figures 6b and 6c.

An alternate arrangement of rectangular contacts allows for smaller cell pitch which results in higher cell integration density and lower device resistance.

The lightly doped source 5b may surround the body contact region 6 and the source contact 5a. The length of the transition from the source contact 5a to the channel 8 in the lightly doped source 5b can have an arbitrary value, but it may be rather small due to higher sheet resistance of the lightly doped material.

When using the alternate contact arrangement as shown in Figures 6b and 6c, both the body contact 6 and the source contact 5a can extend below the interlayer dielectric and even further below the gate and can terminate before the lightly doped source 5b / channel 8 junction is reached. The stripe and alternate square contact arrangements are shown in Figures 6b and 6c.

In the design of the MOS device 100 shown in Figures 6a and 6b and 6c, the body contact region 6 is marked with vertical stripes and the first region 5a of the current input electrode 25 is marked with positive-slope stripes.

Fig. 6a shows a design of a MOS device 100 according to the disclosure where the body contact 6 and the source contact 5a are arranged parallel to the gate 10.

Fig. 6b shows a design of a MOS device 100 according to the disclosure with an alternate rectangular body contact 6 and a source contact 5a of the same length along the gate 10.

In the design of the MOS device 100 shown in Figure 6b, the body contact region 6 and the first region 5a of the current input electrode 25 can be rectangularly shaped, wherein the rectangles of the body contact region 6 and the rectangles of the first region 5a of the current input electrode 25 may have a same length and can be alternately arranged across the top side of the MOS device 100.

Fig. 6c shows a design of a MOS device 100 according to the invention with an alternate rectangular body contact 6 of a shorter length and a source contact 5a along the gate 10.

In the design of the MOS device 100 shown in Figure 6c, the body contact region 6 and the first region 5a of the current input electrode 25 can be rectangularly shaped, wherein the rectangles of the body contact region 6 and the rectangles of the first region 5a of the current input electrode 25 may be alternately arranged across the top side of the MOS device. The rectangles of the body contact region 6 may have a shorter length than the rectangles of the first region 5a of the current input electrode 25 as shown in Figure 6c.

Fig. 7 shows a schematic diagram illustrating a method 700 for producing a MOS device 100 according to the disclosure. The method 700 can be used to produce a MOS device 100 as described above with respect to Figures 1 to 3 and 6. The method steps may implement the production steps described above with respect to Figures 4 and 5.

The method 700 can be used for producing a MOS device 100 as described above. This MOS device 100 comprises a top side and a bottom side opposing the top side.

The key point of this method 700 and of this disclosure as a whole is the separation of the current input electrode (e.g., source region) into two regions or parts, i.e., the first region 5a and the second region 5b described below. Note that the steps 701 to 709 shown in Figure 7 are not necessarily describing a process flow but only the relevant steps for performing the method 700 that may correspond to any of the methods described above with respect to Figures 4 and 5.

In particular, Figure 7 presents the following two cases that are included by the method 700:
Case 1:
   arranging 701 a current output electrode 1 of a first semiconductor doping type or of a second semiconductor doping type on the bottom side of the MOS device 100, e.g., as described above with respect to Figures 1 to 6;
   forming 702 a buffer layer 2 of the first semiconductor doping type above the current output electrode 1, e.g., as described above with respect to Figures 1 to 6;
   forming 703 a drift layer 3 of the first semiconductor doping type above the buffer layer 2, e.g., as described above with respect to Figures 1 to 6;
   embedding 704 a body region 4 of the second semiconductor doping type in the drift layer 3, the body region 4 forming a Junction Field Effect Transistor, JFET, region 7 in the drift layer 3, e.g., as described above with respect to Figures 1 to 6;
   forming a second region 5b of a current input electrode, e.g., as described above with respect to Figures 1 to 6;
   forming a first region 5a of the current input electrode and forming a body contact region 6, e.g., as described above with respect to Figures 1 to 6;
   forming 707 one or more insulation layers 9, 13, e.g., as described above with respect to Figures 1 to 6;
   forming 708 a control electrode 10 on top of the insulation layers 9, e.g., as described above with respect to Figures 1 to 6;
   electrically insulating 709 the current input electrode 25 from the control electrode 10 by the one or more insulation layers 9, 13. A channel 8 of the MOS device 100 is formed between a junction of the second region 5b of the current input electrode 25 to the body region 4 and a junction of the body region 4 to the JFET region 7, e.g., as described above with respect to Figures 1 to 6.
Case 2:
   arranging 701 a current output electrode 1 of a first semiconductor doping type or of a second semiconductor doping type on the bottom side of the MOS device 100, e.g., as described above with respect to Figures 1 to 6;
   forming 702 a buffer layer 2 of the first semiconductor doping type above the current output electrode 1, e.g., as described above with respect to Figures 1 to 6;
   forming 703 a drift layer 3 of the first semiconductor doping type above the buffer layer 2, e.g., as described above with respect to Figures 1 to 6;
   forming a first region 5a of a current input electrode and forming a body contact region 6, e.g., as described above with respect to Figures 1 to 6;
   embedding 704 a body region 4 of the second semiconductor doping type in the drift layer 3, the body region 4 forming a Junction Field Effect Transistor, JFET, region 7 in the drift layer 3, e.g., as described above with respect to Figures 1 to 6;
   forming a second region 5b of the current input electrode, e.g., as described above with respect to Figures 1 to 6;
   forming 707 one or more insulation layers 9, 13, e.g., as described above with respect to Figures 1 to 6;
   forming 708 a control electrode 10 on top of the insulation layers 9, e.g., as described above with respect to Figures 1 to 6;
   electrically insulating 709 the current input electrode 25 from the control electrode 10 by the one or more insulation layers 9, 13. A channel 8 of the MOS device 100 is formed between a junction of the second region 5b of the current input electrode 25 to the body region 4 and a junction of the body region 4 to the JFET region 7, e.g., as described above with respect to Figures 1 to 6.

The one or more insulation layers 9, 13 may be formed or fabricated in separate steps.

In one example, the process flow is as follows: forming substrate, forming buffer layer, forming drift layer, forming body region, forming source (input electrode), forming body contact region, optionally forming some other optional implantations not considered in this disclosure, forming gate oxide (insulation layer 9), forming gate electrode, forming interlayer dielectric (insulation layer 13), etching of interlayer dielectric in contact region 11, contact metallization 11, front side metal 14, backside metal 1.

The buffer layer 2 can be a first deposited layer. The drift layer 3 can be a second deposited layer. Note that the production method is not limited to these two layers, i.e., forming buffer layer 2 and forming drift layer 3. It understands that even more layers can be formed. Particularly, the drift layer 3 can be decomposed into few layers 3a, 3b, 3c, ... which have different functions. In other words, there are basically two layers (layer 2 and layer 3) but the number of layers is not limited to 2. There may be other layer having another function than the drift layer and the buffer layer, e.g., a recombination-enhancement layer, a current spreading layer, etc.

The method 700 may further comprise any of the following steps: forming a first mask layer M1 above the JFET region 7; implanting the body region 4 of the second semiconductor doping type in the drift layer 3 by using the first mask layer M1; forming a spacer mask layer M2 above part of the body region 4, the spacer mask layer M2 contacting the first mask layer M1; implanting the second region 5b of the current input electrode 25 in the body region 4 after the forming of the spacer mask layer M2; removal of the first mask layer M1 and the spacer mask layer M2; patterning and implanting the first region 5a and the body contact region 6 prior to the forming the first mask layer M1; or patterning and implanting the first region 5a and the body contact region 6 after removal of the first mask layer M1 and the spacer mask layer M2, e.g., as described above with respect to Figures 1 to 6, in particular Figures 4 and 5.

Implanting the second region 5b of the current input electrode 25 can be co-implanting the implantation of the first region 5a of the current input electrode 25 and the body contact region 6, e.g., as described above with respect to Figures 1 to 6.

Implanting the second region 5b of the current input electrode 25 may determine a length of the channel 8 that can be defined by a distance between a junction of the second region 5b of the current input electrode 25 to the body region 4 and a junction of the body region 4 to the JFET region 7.

In a further step for producing the MOS device 100, the front side of the MOS device may be covered with a metal layer 14 (front side metal 14) which connects the contact region 11 (e.g., forming the Source pad or Emitter pad) and which may be separated from the control electrode (gate) 10 by the interlayer dielectric 13. Outside of the active area of the device the control electrode (gate) 10 may be connected to the metal 14 and separated from source (so called gate pad, not presented in the figures). The backside may be metallized with the metal 15. Additional passivation layers on the front side of the device may be formed (not shown in the figures).

While a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the disclosure beyond those described herein. While the disclosure has been described with reference to one or more particular embodiments, those skilled in the art recognize that many changes may be made thereto without departing from the scope of the appended claims.

## Claims

1. A Metal-Oxide-Semiconductor, MOS, device (100), comprising:
a control electrode (10) arranged on a top side of the MOS device (100);
a current output electrode (1) of a first semiconductor doping type or of a second semiconductor doping type, the current output electrode (1) being arranged on a bottom side of the MOS device (100), the bottom side opposing the top side;
a buffer layer (2) of the first semiconductor doping type formed above the current output electrode (1) and a drift layer (3) of the first semiconductor doping type formed above the buffer layer (2);
a body region (4) of the second semiconductor doping type, embedded in the drift layer (3), the body region (4) configured to form a Junction Field Effect Transistor, JFET, region (7) in the drift layer (3) below the control electrode (10);
a current input electrode (25) comprising a first region (5a) and a second, lightly doped, region (5b) of the first semiconductor doping type embedded in the body region (4), the current input electrode (25) being configured to be electrically insulated from the control electrode (10) by one or more insulation layers (9, 13); and
a body contact region (6) of the second semiconductor doping type electrically contacting the body region (4), wherein the body contact region (6) is configured to electrically contact the current input electrode (25);
wherein a channel (8) of the MOS device (100) is configured to be formed between a junction (26) of the second, lightly doped, region (5b) of the current input electrode (25) to the body region (4) and a junction (27) of the body region (4) to the JFET region (7);
wherein the first region (5a) of the current input electrode (25) and the second, lightly doped, region (5b) of the current input electrode (25) comprise different dopant atoms of the same doping type, wherein the doping concentration of the second, lightly doped, region (5b) of the current input electrode (25) is lower than a doping concentration of the first region (5a) of the current input electrode (25);
wherein the body contact region (6) and the first region (5a) of the current input electrode (25) are rectangularly shaped, wherein the rectangles of the body contact region (6) and the rectangles of the first region (5a) of the current input electrode (25) are alternately arranged across the top side of the MOS device along a direction parallel to the control electrode (10), and wherein the rectangles of the body contact region (6) have a shorter length, in a direction perpendicular to the control electrode (10), than the rectangles of the first region (5a) of the current input electrode (25).

2. The MOS device (100) of claim 1,
wherein a semiconductor doping concentration of the second region (5b) of the current input electrode (25) is lower than a semiconductor doping concentration of the body contact region (6).

3. The MOS device (100) of any of the preceding claims,
wherein a semiconductor doping concentration of the second region (5b) of the current input electrode (25) is at least one order of magnitude lower than a semiconductor doping concentration of the first region (5a) of the current input electrode (25).

4. The MOS device (100) of any of the preceding claims,
wherein a depth (28) of the second region (5b) of the current imput electrode (25) is smaller than a depth (29) of the first region (5a) so that the current input electrode (25) of the MOS device (100) is shaped according to a step profile, or
wherein the current input electrode (25) of the MOS device (100) comprises two semiconductor doping concentrations of the first semiconductor doping type and the second region (5b) extends beyond the first region (5a) in both vertical and lateral direction.

5. The MOS device (100) of any of the preceding claims,
wherein a length of the channel (8) is based on the semiconductor doping concentration of the second region (5b) of the current input electrode (25).

6. The MOS device (100) of claim 1, comprising:
an input contact metallization (11) spreading over the body contact region (6) and a part of the current input electrode (25),
wherein a thickness of the first region (5a) of the current input electrode (25) below the input contact metallization (11) is smaller than a thickness of the first region (5a) of the current input electrode (25) outside the input contact metallization (11).

7. A method (700) for producing a Metal-Oxide-Semiconductor, MOS, device (100), the MOS device comprising a top side and a bottom side opposing the top side, the method comprising:
arranging (701) a current output electrode (1) of a first semiconductor doping type or of a second semiconductor doping type on the bottom side of the MOS device (100);
forming (702) a buffer layer (2) of the first semiconductor doping type above the current output electrode (1);
forming (703) a drift layer (3) of the first semiconductor doping type above the buffer layer (2);
embedding (704) a body region (4) of the second semiconductor doping type in the drift layer (3), the body region (4) forming a Junction Field Effect Transistor, JFET, region (7) in the drift layer (3);
forming (705) a body contact region (6) in the body region (4), the body contact region (6) electrically contacting the body region (4);
arranging (706) a current input electrode (25) on the top side of the MOS device (100) embedded in the body region (4), the current input electrode (25) comprising a first region (5a) and a second, lightly doped, region (5b) of the first semiconductor doping type;
forming (707) one or more insulation layers (9, 13);
forming (708) a control electrode (10) on top of the insulation layer (9);
electrically insulating (709) the current input electrode (25) from the control electrode (10) by the one or more insulation layers (9, 13); and
wherein a channel (8) of the MOS device (100) is formed between a junction of the second, lightly doped, region (5b) of the current input electrode (25) to the body region (4) and a junction of the body region (4) to the JFET region (7);
wherein the first region (5a) of the current input electrode (25) and the second, lightly doped, region (5b) of the current input electrode (25) comprise different dopant atoms of the same doping type, wherein the doping concentration of the second, lightly doped, region (5b) of the current input electrode (25) is lower than a doping concentration of the first region (5a) of the current input electrode (25);
wherein the body contact region (6) and the first region (5a) of the current input electrode (25) are rectangularly shaped, wherein the rectangles of the body contact region (6) and the rectangles of the first region (5a) of the current input electrode (25) are alternately arranged across the top side of the MOS device along a direction parallel to the control electrode (10), and wherein the rectangles of the body contact region (6) have a shorter length, in a direction perpendicular to the control electrode (10), than the rectangles of the first region (5a) of the current input electrode (25).

8. The method (700) of claim 9, comprising:
forming a first mask layer (M1) above the JFET region (7);
implanting the body region (4) of the second semiconductor doping type in the drift layer (3) by using the first mask layer (M1);
forming a spacer mask layer (M2) above part of the body region (4), the spacer mask layer (M2) contacting the first mask layer (M1);
implanting the second region (5b) of the current input electrode (25) in the body region (4) after the forming of the spacer mask layer (M2);
removal of the first mask layer (M1) and the spacer mask layer (M2);
patterning and implanting the first region (5a) and the body contact region (6) prior to the forming the first mask layer (M1); or
patterning and implanting the first region (5a) and the body contact region (6) after removal of the first mask layer (M1) and the spacer mask layer (M2).

9. The method (700) of claim 10,
wherein implanting the second region (5b) of the current input electrode (25) is co-implanting the implantation of the first region (5a) of the current input electrode (25) and the body contact region (6), and/or
wherein implanting the second region (5b) of the current input electrode (25) determines a length of the channel (8) that is defined by a distance between a junction of the second region (5b) of the current input electrode (25) to the body region (4) and a junction of the body region (4) to the JFET region (7).

## Patentansprüche

1. Metall-Oxid-Halbleiter(MOS)-Vorrichtung (100), die umfasst:
eine Steuerelektrode (10), die auf einer Oberseite der MOS-Vorrichtung (100) angeordnet ist;
eine Stromausgangselektrode (1) eines ersten Halbleiterdotierungstyps oder eines zweiten Halbleiterdotierungstyps, wobei die Stromausgangselektrode (1) auf einer Unterseite der MOS-Vorrichtung (100) angeordnet ist, wobei die Unterseite der Oberseite gegenüberliegt;
eine Pufferschicht (2) des ersten Halbleiterdotierungstyps, die oberhalb der Stromausgangselektrode (1) ausgebildet ist, und eine Drift-Schicht (3) des ersten Halbleiterdotierungstyps, die oberhalb der Pufferschicht (2) ausgebildet ist;
eine Körperregion (4) des zweiten Halbleiterdotierungstyps, die in die Drift-Schicht (3) eingebettet ist, wobei die Körperregion (4) konfiguriert ist, um eine Sperrschicht-Feldeffekttransistor(JFET)-Region (7) in der Drift-Schicht (3) unterhalb der Steuerelektrode (10) auszubilden;
eine Stromeingangselektrode (25), die eine erste Region (5a) und eine zweite, schwach dotierte Region (5b) des ersten Halbleiterdotierungstyps, die in die Körperregion (4) eingebettet sind, umfasst, wobei die Stromeingangselektrode (25) konfiguriert ist, um von der Steuerelektrode (10) durch eine oder mehrere Isolationsschichten (9, 13) elektrisch isoliert zu sein; und
eine Körperkontaktregion (6) des zweiten Halbleiterdotierungstyps, die die Körperregion (4) elektrisch kontaktiert, wobei die Körperkontaktregion (6) konfiguriert ist, um die Stromeingangselektrode (25) elektrisch zu kontaktieren;
wobei ein Kanal (8) der MOS-Vorrichtung (100) konfiguriert ist, um zwischen einem Übergang (26) der zweiten, schwach dotierten Region (5b) der Stromeingangselektrode (25) zu der Körperregion (4) und einem Übergang (27) der Körperregion (4) zu der JFET-Region (7) ausgebildet zu werden;
wobei die erste Region (5a) der Stromeingangselektrode (25) und die zweite, schwach dotierte Region (5b) der Stromeingangselektrode (25) verschiedene Dotieratome desselben Dotierungstyps umfassen, wobei die Dotierungskonzentration der zweiten, schwach dotierten Region (5b) der Stromeingangselektrode (25) niedriger als eine Dotierungskonzentration der ersten Region (5a) der Stromeingangselektrode (25) ist;
wobei die Körperkontaktregion (6) und die erste Region (5a) der Stromeingangselektrode (25) rechteckig geformt sind, wobei die Rechtecke der Körperkontaktregion (6) und die Rechtecke der ersten Region (5a) der Stromeingangselektrode (25) abwechselnd über die Oberseite der MOS-Vorrichtung entlang einer Richtung parallel zu der Steuerelektrode (10) angeordnet sind, und
wobei die Rechtecke der Körperkontaktregion (6) eine kürzere Länge in einer Richtung senkrecht zu der Steuerelektrode (10) als die Rechtecke der ersten Region (5a) der Stromeingangselektrode (25) aufweisen.

2. MOS-Vorrichtung (100) nach Anspruch 1,
wobei eine Halbleiterdotierungskonzentration der zweiten Region (5b) der Stromeingangselektrode (25) niedriger als eine Halbleiterdotierungskonzentration der Körperkontaktregion (6) ist.

3. MOS-Vorrichtung (100) nach einem der vorstehenden Ansprüche,
wobei eine Halbleiterdotierungskonzentration der zweiten Region (5b) der Stromeingangselektrode (25) mindestens eine Größenordnung niedriger als eine Halbleiterdotierungskonzentration der ersten Region (5a) der Stromeingangselektrode (25) ist.

4. MOS-Vorrichtung (100) nach einem der vorstehenden Ansprüche,
wobei eine Tiefe (28) der zweiten Region (5b) der Stromeingangselektrode (25) kleiner als eine Tiefe (29) der ersten Region (5a) ist, so dass die Stromeingangselektrode (25) der MOS-Vorrichtung (100) gemäß einem Schritt-Profil geformt ist, oder
wobei die Stromeingangselektrode (25) der MOS-Vorrichtung (100) zwei Halbleiterdotierungskonzentrationen des ersten Halbleiterdotierungstyps umfasst und sich die zweite Region (5b) über die erste Region (5a) hinaus sowohl in vertikaler als auch in lateraler Richtung erstreckt.

5. MOS-Vorrichtung (100) nach einem der vorstehenden Ansprüche,
wobei eine Länge des Kanals (8) auf der Halbleiterdotierungskonzentration der zweiten Region (5b) der Stromeingangselektrode (25) basiert.

6. MOS-Vorrichtung (100) nach Anspruch 1, die umfasst:
eine Eingangskontaktmetallisierung (11), die sich über die Körperkontaktregion (6) und einen Teil der Stromeingangselektrode (25) erstreckt,
wobei eine Dicke der ersten Region (5a) der Stromeingangselektrode (25) unterhalb der Eingangskontaktmetallisierung (11) kleiner als eine Dicke der ersten Region (5a) der Stromeingangselektrode (25) außerhalb der Eingangskontaktmetallisierung (11) ist.

7. Verfahren (700) zum Herstellen einer Metall-Oxid-Halbleiter(MOS)-Vorrichtung, (100), wobei die MOS-Vorrichtung eine Oberseite und eine der Oberseite gegenüberliegende Unterseite umfasst, wobei das Verfahren umfasst:
Anordnen (701) einer Stromausgangselektrode (1) eines ersten Halbleiterdotierungstyps oder eines zweiten Halbleiterdotierungstyps auf der Unterseite der MOS-Vorrichtung (100);
Ausbilden (702) einer Pufferschicht (2) des ersten Halbleiterdotierungstyps oberhalb der Stromausgangselektrode (1);
Ausbilden (703) einer Drift-Schicht (3) des ersten Halbleiterdotierungstyps oberhalb der Pufferschicht (2);
Einbetten (704) einer Körperregion (4) des zweiten Halbleiterdotierungstyps in die Drift-Schicht (3), wobei die Körperregion (4) eine Sperrschicht-Feldeffekttransistor(JFET)-Region (7) in der Drift-Schicht (3) ausbildet;
Ausbilden (705) einer Körperkontaktregion (6) in der Körperregion (4), wobei die Körperkontaktregion (6) die Körperregion (4) elektrisch kontaktiert;
Anordnen (706) einer Stromeingangselektrode (25) auf der Oberseite der in der Körperregion (4) eingebetteten MOS-Vorrichtung (100), wobei die Stromeingangselektrode (25) eine erste Region (5a) und eine zweite, schwach dotierte Region (5b) des ersten Halbleiterdotierungstyps umfasst;
Ausbilden (707) einer oder mehrerer Isolationsschichten (9, 13);
Ausbilden (708) einer Steuerelektrode (10) auf der Isolationsschicht (9);
elektrisches Isolieren (709) der Stromeingangselektrode (25) von der Steuerelektrode (10) durch die eine oder mehreren Isolationsschichten (9, 13); und
wobei ein Kanal (8) der MOS-Vorrichtung (100) zwischen einem Übergang der zweiten, schwach dotierten Region (5b) der Stromeingangselektrode (25) zu der Körperregion (4) und einem Übergang der Körperregion (4) zu der JFET-Region (7) ausgebildet ist;
wobei die erste Region (5a) der Stromeingangselektrode (25) und die zweite, schwach dotierte Region (5b) der Stromeingangselektrode (25) verschiedene Dotieratome desselben Dotierungstyps umfassen, wobei die Dotierungskonzentration der zweiten, schwach dotierten Region (5b) der Stromeingangselektrode (25) niedriger als eine Dotierungskonzentration der ersten Region (5a) der Stromeingangselektrode (25) ist;
wobei die Körperkontaktregion (6) und die erste Region (5a) der Stromeingangselektrode (25) rechteckig geformt sind, wobei die Rechtecke der Körperkontaktregion (6) und die Rechtecke der ersten Region (5a) der Stromeingangselektrode (25) abwechselnd über die Oberseite der MOS-Vorrichtung entlang einer Richtung parallel zu der Steuerelektrode (10) angeordnet sind, und
wobei die Rechtecke der Körperkontaktregion (6) eine kürzere Länge in einer Richtung senkrecht zu der Steuerelektrode (10) als die Rechtecke der ersten Region (5a) der Stromeingangselektrode (25) aufweisen.

8. Verfahren (700) nach Anspruch 9, das umfasst:
Ausbilden einer ersten Maskierungsschicht (M1) oberhalb der JFET-Region (7);
Implantieren der Körperregion (4) des zweiten Halbleiterdotierungstyps in die Drift-Schicht (3) durch Verwenden der ersten Maskierungsschicht (M1);
Ausbilden einer Abstandshaltermaskierungsschicht (M2) oberhalb eines Teils der Körperregion (4), wobei die Abstandshaltermaskierungsschicht (M2) die erste Maskierungsschicht (M1) kontaktiert;
Implantieren der zweiten Region (5b) der Stromeingangselektrode (25) in die Körperregion (4) nach dem Ausbilden der Abstandshaltermaskierungsschicht (M2);
Entfernen der ersten Maskierungsschicht (M1) und der Abstandshaltermaskierungsschicht (M2);
Strukturieren und Implantieren der ersten Region (5a) und der Körperkontaktregion (6) vor dem Ausbilden der ersten Maskierungsschicht (M1); oder
Strukturieren und Implantieren der ersten Region (5a) und der Körperkontaktregion (6) nach Entfernen der ersten Maskierungsschicht (M1) und der Abstandshaltermaskierungsschicht (M2).

9. Verfahren (700) nach Anspruch 10,
wobei das Implantieren der zweiten Region (5b) der Stromeingangselektrode (25) ein Co-Implantieren der Implantation der ersten Region (5a) der Stromeingangselektrode (25) und der Körperkontaktregion (6) ist, und/oder
wobei das Implantieren der zweiten Region (5b) der Stromeingangselektrode (25) eine Länge des Kanals (8), die durch eine Entfernung zwischen einem Übergang der zweiten Region (5b) der Stromeingangselektrode (25) zu der Körperregion (4) und einem Übergang der Körperregion (4) zu der JFET-Region (7) definiert ist, bestimmt.

## Revendications

1. Dispositif de type métal-oxyde-semi-conducteur, MOS (100), comprenant :
une électrode de commande (10) agencée sur une face supérieure du dispositif MOS (100) ;
une électrode de sortie de courant (1) d'un premier type de dopage de semi-conducteur ou d'un second type de dopage de semi-conducteur, l'électrode de sortie de courant (1) étant agencée sur une face inférieure du dispositif MOS (100), la face inférieure étant opposée à la face supérieure ;
une couche tampon (2) du premier type de dopage de semi-conducteur formée au-dessus de l'électrode de sortie de courant (1) et une couche de dérive (3) du premier type de dopage de semi-conducteur formée au-dessus de la couche tampon (2) ;
une région de corps (4) du second type de dopage de semi-conducteur, intégrée dans la couche de dérive (3), la région de corps (4) étant conçue pour former une région de transistor à effet de champ à jonction, JFET (7), dans la couche de dérive (3) en dessous de l'électrode de commande (10) ;
une électrode d'entrée de courant (25) comprenant une première région (5a) et une seconde région légèrement dopée (5b) du premier type de dopage de semi-conducteur intégrée dans la région de corps (4), l'électrode d'entrée de courant (25) étant configurée pour être électriquement isolée de l'électrode de commande (10) par une ou plusieurs couches d'isolation (9, 13) ; et
une région de contact de corps (6) du second type de dopage de semi-conducteur en contact électrique avec la région de corps (4), dans lequel la région de contact de corps (6) est configurée pour entrer électriquement en contact avec l'électrode d'entrée de courant (25) ;
dans lequel un canal (8) du dispositif MOS (100) est conçu pour être formé entre une jonction (26) de la seconde région légèrement dopée (5b) de l'électrode d'entrée de courant (25) avec la région de corps (4) et une jonction (27) de la région de corps (4) avec la région JFET (7) ;
dans lequel la première région (5a) de l'électrode d'entrée de courant (25) et la seconde région légèrement dopée (5b) de l'électrode d'entrée de courant (25) comprennent différents atomes de dopant du même type de dopage, dans lequel la concentration de dopage de la seconde région légèrement dopée (5b) de l'électrode d'entrée de courant (25) est inférieure à une concentration de dopage de la première région (5a) de l'électrode d'entrée de courant (25) ;
dans lequel la région de contact de corps (6) et la première région (5a) de l'électrode d'entrée de courant (25) sont de forme rectangulaire, dans lequel les rectangles de la région de contact de corps (6) et les rectangles de la première région (5a) de l'électrode d'entrée de courant (25) sont agencés alternativement sur la face supérieure du dispositif MOS le long d'une direction parallèle à l'électrode de commande (10), et dans lequel les rectangles de la région de contact de corps (6) ont une longueur plus courte, dans une direction perpendiculaire à l'électrode de commande (10), que les rectangles de la première région (5a) de l'électrode d'entrée de courant (25).

2. Dispositif MOS (100) selon la revendication 1,
dans lequel une concentration de dopage de semi-conducteur de la seconde région (5b) de l'électrode d'entrée de courant (25) est inférieure à une concentration de dopage de semi-conducteur de la région de contact de corps (6).

3. Dispositif MOS (100) selon l'une quelconque des revendications précédentes,
dans lequel une concentration de dopage de semi-conducteur de la seconde région (5b) de l'électrode d'entrée de courant (25) est inférieure d'au moins un ordre de grandeur à une concentration de dopage de semi-conducteur de la première région (5a) de l'électrode d'entrée de courant (25).

4. Dispositif MOS (100) selon l'une quelconque des revendications précédentes,
dans lequel une profondeur (28) de la seconde région (5b) de l'électrode d'entrée de courant (25) est inférieure à une profondeur (29) de la première région (5a) de sorte que l'électrode d'entrée de courant (25) du dispositif MOS (100) est mise en forme selon un profil de gradin, ou
dans lequel l'électrode d'entrée de courant (25) du dispositif MOS (100) comprend deux concentrations de dopage de semi-conducteur du premier type de dopage de semi-conducteur et la seconde région (5b) s'étend au-delà de la première région (5a) à la fois dans la direction verticale et dans la direction latérale.

5. Dispositif MOS (100) selon l'une quelconque des revendications précédentes,
dans lequel une longueur du canal (8) est basée sur la concentration de dopage de semi-conducteur de la seconde région (5b) de l'électrode d'entrée de courant (25).

6. Dispositif MOS (100) selon la revendication 1, comprenant :
une métallisation de contact d'entrée (11) s'étendant sur la région de contact de corps (6) et une partie de l'électrode d'entrée de courant (25),
dans lequel une épaisseur de la première région (5a) de l'électrode d'entrée de courant (25) en dessous de la métallisation de contact d'entrée (11) est plus petite qu'une épaisseur de la première région (5a) de l'électrode d'entrée de courant (25) en dehors de la métallisation de contact d'entrée (11).

7. Procédé (700) pour la production d'un dispositif de type métal-oxyde-semi-conducteur, MOS (100), le dispositif MOS comprenant une face supérieure et une face inférieure opposée à la face supérieure, le procédé comprenant :
l'agencement (701) d'une électrode de sortie de courant (1) d'un premier type de dopage de semi-conducteur ou d'un second type de dopage de semi-conducteur sur la face inférieure du dispositif MOS (100) ;
la formation (702) d'une couche tampon (2) du premier type de dopage de semi-conducteur au-dessus de l'électrode de sortie de courant (1) ;
la formation (703) d'une couche de dérive (3) du premier type de dopage de semi-conducteur au-dessus de la couche tampon (2) ;
l'intégration (704) d'une région de corps (4) du second type de dopage de semi-conducteur dans la couche de dérive (3), la région de corps (4) formant une région de transistor à effet de champ à jonction, JFET (7), dans la couche de dérive (3) ;
la formation (705) d'une région de contact de corps (6) dans la région de corps (4), la région de contact de corps (6) entrant électriquement en contact avec la région de corps (4) ;
l'agencement (706) d'une électrode d'entrée de courant (25) sur la face supérieure du dispositif MOS (100) intégrée dans la région de corps (4), l'électrode d'entrée de courant (25) comprenant une première région (5a) et une seconde région légèrement dopée (5b) du premier type de dopage de semi-conducteur ;
la formation (707) d'une ou de plusieurs couches d'isolation (9, 13) ;
la formation (708) d'une électrode de commande (10) sur la couche d'isolation (9) ;
l'isolation électrique (709) de l'électrode d'entrée de courant (25) de l'électrode de commande (10) avec la ou les couches d'isolation (9, 13) ; et
dans lequel un canal (8) du dispositif MOS (100) est formé entre une jonction de la seconde région légèrement dopée (5b) de l'électrode d'entrée de courant (25) avec la région de corps (4) et une jonction de la région de corps (4) avec la région JFET (7) ;
dans lequel la première région (5a) de l'électrode d'entrée de courant (25) et la seconde région légèrement dopée (5b) de l'électrode d'entrée de courant (25) comprennent différents atomes de dopant du même type de dopage, dans lequel la concentration de dopage de la seconde région légèrement dopée (5b) de l'électrode d'entrée de courant (25) est inférieure à une concentration de dopage de la première région (5a) de l'électrode d'entrée de courant (25) ;
dans lequel la région de contact de corps (6) et la première région (5a) de l'électrode d'entrée de courant (25) sont de forme rectangulaire, dans lequel les rectangles de la région de contact de corps (6) et les rectangles de la première région (5a) de l'électrode d'entrée de courant (25) sont agencés alternativement sur la face supérieure du dispositif MOS le long d'une direction parallèle à l'électrode de commande (10), et dans lequel les rectangles de la région de contact de corps (6) ont une longueur plus courte, dans une direction perpendiculaire à l'électrode de commande (10), que les rectangles de la première région (5a) de l'électrode d'entrée de courant (25).

8. Procédé (700) selon la revendication 9, comprenant :
la formation d'une première couche de masque (M1) au-dessus de la région JFET (7) ;
l'implantation de la région de corps (4) du second type de dopage de semi-conducteur dans la couche de dérive (3) en utilisant la première couche de masque (M1) ;
la formation d'une couche de masque d'espacement (M2) au-dessus d'une partie de la région de corps (4), la couche de masque d'espacement (M2) étant en contact avec la première couche de masque (M1) ;
l'implantation de la seconde région (5b) de l'électrode d'entrée de courant (25) dans la région de corps (4) après la formation de la couche de masque d'espacement (M2) ;
le retrait de la première couche de masque (M1) et de la couche de masque d'espacement (M2) ;
le modelage de contours et l'implantation de la première région (5a) et de la région de contact de corps (6) avant la formation de la première couche de masque (M1) ; ou
le modelage de contours et l'implantation de la première région (5a) et de la région de contact de corps (6) après le retrait de la première couche de masque (M1) et de la couche de masque d'espacement (M2).

9. Procédé (700) selon la revendication 10,
dans lequel l'implantation de la seconde région (5b) de l'électrode d'entrée de courant (25) est la co-implantation de l'implantation de la première région (5a) de l'électrode d'entrée de courant (25) et de la région de contact de corps (6), et/ou
dans lequel l'implantation de la seconde région (5b) de l'électrode d'entrée de courant (25) détermine une longueur du canal (8) qui est définie par une distance entre une jonction de la seconde région (5b) de l'électrode d'entrée de courant (25) avec la région de corps (4) et une jonction de la région de corps (4) avec la région JFET (7).
